# EUROPÄISCHE PATENTANMELDUNG

(11) **EP 3 046 399 A1**
(43) Veröffentlichungstag der Anmeldung: **20.07.2016**
(21) Anmeldenummer: 15151417.1
(22) Anmeldetag: 16.01.2015
(51) Int. Cl.: H05K 1/11, H05K 1/02, H05K 1/18, H05K 3/32

(54) **Elektrische Kontaktierung einer OLED und mit einer entsprechend elektrisch kontaktierten OLED ausgestattete Fahrzeugleuchte**

(71) Anmelder: odelo GmbH, 70329 Stuttgart (DE)
(72) Erfinder: Vollmer, Marco, 71332 Waiblingen (DE); Vlastnik, Andreas, 71640 Ludwigsburg (DE)
(74) Vertreter: Benninger, Johannes

(57) **Zusammenfassung**

Es wird eine elektrische Kontaktierung (01) mindestens einer OLED (02) und eine eine solche elektrische Kontaktierung (01) umfassende Fahrzeugleuchte beschrieben. Die elektrische Kontaktierung (01) zeichnet sich aus durch mindestens eine wenigstens einen ersten Abschnitt (31) und zumindest einen zweiten Abschnitt (32) aufweisende starrflexible Leiterplatte (03) bestehend aus elektrisch isolierendem Material (30) mit daran haftenden Leiterbahnen (33, 39). In dem zumindest einen ersten Abschnitt (31) ist das elektrisch isolierende Material (30) von der Unterseite (34) der starrflexiblen Leiterplatte (03) her gesehen zwischen zwei parallel zu der mit Leiterbahnen (33) versehenen Oberseite (35) verlaufenden Geraden (36, 37) zumindest teilweise, höchstens jedoch bis zu den Leiterbahnen (33) der Oberseite (35) ausgespart. Der wenigstens eine zweite Abschnitt (32) ist frei von einer solchen Aussparung. Zumindest ein Teil der Leiterbahnen (33, 39) sind in wenigstens einem zweiten Abschnitt (32) zu Kontaktflächen (38) ausgebildet. Die elektrische Kontaktierung (01) zeichnet sich ferner aus durch eine elektrische Erstkontaktierung (04) der mindestens einen OLED (02) umfassend elektrisch leitfähige Verbindungen (40) zwischen je einem elektrischen Anschluss (20) der OLED (02) und je einer Leiterbahn (33, 39) der starrflexiblen Leiterplatte (03). Die elektrische Kontaktierung (01) zeichnet sich außerdem aus durch eine elektrische Zweitkontaktierung (05) der mindestens einen OLED (02) umfassend mindestens eine Direktsteckverbindung (50) zwischen mit der Weiterkontaktierung dienenden elektrischen Leitungen (06) elektrisch verbundenen Kontaktmitteln (51) und den zu Kontaktflächen (38) ausgebildeten Leiterbahnen (33, 39) der starrflexiblen Leiterplatte (03). Die Kontaktmittel (51) der Direktsteckverbindung (50) sind von einem Rand her auf einen mit zu Kontaktflächen (38) ausgebildeten Leiterbahnen (33, 39) versehenen und von dem mit seinen Leiterbahnen (33) von der OLED (02) erstkontaktierten Abschnitt (31, 32) verschiedenen zweiten Abschnitt (32) der starrflexiblen Leiterplatte (03) her aufschiebbar oder aufgeschoben.

## Beschreibung

Die Erfindung betrifft eine elektrische Kontaktierung einer OLED gemäß dem Oberbegriff des Anspruchs 1 sowie eine mit einer entsprechenden elektrischen Kontaktierung einer OLED ausgestattete Fahrzeugleuchte gemäß dem Oberbegriff des Anspruchs 14.

Aufgrund ihres hohen Wirkungsgrads bei der Umwandlung von elektrischem Strom in für das menschliche Auge sichtbares Licht kommen als Lichtquellen von Leuchtmitteln für Fahrzeugleuchten vermehrt anorganische Leuchtdioden oder organische Leuchtdioden zum Einsatz.

Anorganische Leuchtdioden bestehen aus mindestens einem Lichtemittierende-Diode-Halbleiter-Chip, kurz LED-Chip, sowie wenigstens einer beispielsweise durch Spritzgießen angeformten, den mindestens einen LED-Chip ganz oder teilweise umhüllenden Primäroptik. Auch sind Fahrzeugleuchten bekannt, in denen reine LED-Chips ohne angeformte Primäroptiken zum Einsatz kommen.

Im Folgenden wird deshalb der Einfachheit halber nicht mehr zwischen anorganischer Leuchtdiode und LED-Chip unterschieden und statt dessen einheitlich der Begriff LED stellvertretend für beides verwendet, es sei denn, es ist explizit etwas anderes erwähnt. Herausragende Eigenschaften von LEDs im Vergleich zu anderen, konventionellen Lichtquellen von Leuchtmitteln sind eine wesentlich längere Lebensdauer und eine wesentlich höhere Lichtausbeute bei gleicher Leistungsaufnahme. Mit anderen Worten weisen LEDs bei gleicher Lichtstärke einen im Vergleich zu anderen Lichtquellen geringeren Stromverbrauch auf. Hierdurch kann bei einer Verwendung einer oder mehrerer LEDS als Lichtquelle eines Leuchtmittels beispielsweise in einer Fahrzeugleuchte die Belastung eines zur Stromversorgung vorgesehenen Bordnetzes eines Fahrzeugs verringert werden, einhergehend mit Einsparungen beim Energieverbrauch des Fahrzeugs. Ferner weisen LEDs eine weit höhere Lebensdauer auf, als andere, zur Anwendung in einer Fahrzeugleuchte in Frage kommende Lichtquellen. Durch die längere Lebensdauer wird unter Anderem durch die geringere Ausfallquote die Betriebssicherheit und damit einhergehend die Qualität der Fahrzeugleuchte erhöht.

Eine kurz als OLED (Organic Light Emitting Diode; OLED) bezeichnete organische Leuchtdiode ist ein leuchtendes Dünnschichtbauelement aus organischen halbleitenden Materialien mit mindestens einer zwischen elektrisch leitenden, beispielsweise metallischen Schichten für Anode und Kathode eingeschlossen Emitterschicht. Die Stärke oder anders ausgedrückt Dicke der Schichten liegt in einer Größenordnung von etwa 100 nm. Typischerweise beträgt sie je nach Aufbau 100 nm bis 500 nm. Zum Schutz gegen Wasser, Sauerstoff sowie zum Schutz gegen andere Umwelteinflüsse, wie etwa Kratzbeschädigung und/oder Druckbelastung sind OLEDs typischerweise mit einem anorganischen Material insbesondere mit Glas verkapselt. Zwar gibt es Anstrengungen, das Glas durch Kunststoff zu ersetzen, die jedoch insbesondere um beispielsweise die Lebensdaueranforderung von Fahrzeugleuchten und deren Lichtquellen mit mehreren 1000 Stunden hinreichend gut zu erfüllen noch nicht vom gewünschten Erfolg gekrönt sind, weil die Dichtigkeit der alternativen Materialien für die Verkapselung nicht ausreichend gut genug ist.

Im Unterschied zu anorganischen Leuchtdioden benötigen OLEDs keine einkristallinen Materialien. Im Vergleich zu LEDs lassen sich OLEDs daher in kostengünstiger Dünnschichttechnik herstellen. OLEDs ermöglichen dadurch die Herstellung flächiger Lichtquellen, die einerseits sehr dünn und andererseits als durch die Lichtscheibe einer Fahrzeugleuchte hindurch sichtbare leuchtende Fläche eingesetzt einen besonders homogenes Erscheinungsbild aufweisen.

Ein generelles Ziel bei der Entwicklung von Fahrzeugteilen, wie beispielsweise Fahrzeugleuchten, sind geringe Herstellungskosten einhergehend mit einer sich kostensenkend auf die Herstellungskosten auswirkenden geringen Ausschussquote.

Mindestens zwei Eigenheiten bei der elektrischen Kontaktierung von OLEDs stehen diesem Ziel entgegen.

Eine erste Eigenheit ergibt sich durch die Einschränkung, dass OLEDs nicht so temperaturstabil wie LEDs sind. Dadurch können OLEDs nicht in gleicher Weise vermittels ansonsten bei der Bestückung von Leiterbahnträgern mit Elektronikbauteilen, wie beispielsweise LEDs, in der Serienfertigung erfolgreich angewandten Lötprozessen elektrisch kontaktiert werden. Es ist allerdings zwischenzeitlich möglich - auch in automatisierter Form - mittels Löten OLEDs zu kontaktieren. Oft ist allerdings die Kontaktierungsqualität noch nicht so gut wie vermittels des so genannten ACF-Bondings (ACF; Anisotropic conductive film) vermittels Leitkleber.

Zum Erhalt einer hohen Kontaktierungsqualität ist es daher vorteilhaft, OLEDs zunächst vermittels einer elektrischen Erstkontaktierung, die beispielsweise durch Drahtbonden (Wire-Bonding) oder durch ACF-Bonding vermittels Leitkleber eine elektrische Verbindung zwischen den elektrischen Anschlüssen einer OLED und elektrischen Leiterbahnen eines Leiterbahnträgers herstellt, zu kontaktieren. Zur finalen Herstellung einer elektrischen Kontaktierung von OLEDs ist weiterhin eine elektrische Zweitkontaktierung zwischen den elektrischen Leiterbahnen des Leiterbahnträgers und beispielsweise zu einem Kabelbaum zusammengefassten, der Weiterkontaktierung beispielsweise innerhalb einer Fahrzeugleuchte dienenden elektrischen Leitungen vorgesehen. In Fahrzeugleuchten umfasst die elektrische Zweitkontaktierung bevorzugt eine lösbare oder unlösbare elektrische Steckverbindung.

Eine weitere Möglichkeit zur Kontaktierung von OLEDs stellen in MID-Technik (MID-Technik: Molded-Interconnect-Device-Technik) hergestellte spritzgegossene Schaltungsträger dar. Hierbei werden mit den elektrischen Anschlüssen einer OLED durch Draht- oder ACF-Bonding zu kontaktierende Leiterbahnen in ein Spritzgussteil, welches gleichzeitig als Träger der OLED dient, im Spritzgussprozess integriert. Zur Weiterkontaktierung mit den Leitungen beispielsweise eines leuchteninternen Kabelbaums werden indirekte Steckverbindungen eingesetzt. Nachteilig hieran sind sehr hohe Entwicklungs- und Stückkosten sowohl für den spritzgegossenen Schaltungsträger, als auch die indirekte Steckverbindung.

Weit verbreitetste Leiterbahnträger sind kurz als Leiterkarte, Platine oder gedruckte Schaltung (printed circuit board, PCB) bezeichnete, starre Leiterplatten.

Eine Leiterplatte ist ein Träger für elektronische Bauteile. Sie dient der mechanischen Befestigung und elektrischen Verbindung. Nahezu jedes elektronische Gerät enthält eine oder mehrere Leiterplatten.

Die Herstellung einer elektrischen Erstkontaktierung einer OLED vermittels Drahtbonden oder ACF-Bonding kann am zuverlässigsten einhergehend mit geringmöglichstem Ausschuss in Verbindung mit starren Leiterplatten, wie beispielsweise FR-4 Platinen durchgeführt werden.

Dies führt unweigerlich zur zweiten Eigenheit bei der elektrischen Kontaktierung von OLEDs.

Aufgrund des zumindest in Fahrzeuganwendungen absehbar auf längere Zeit weiterhin Glasplättchen als anorganische Deck- und Basisschichten umfassenden Aufbaus von OLEDs sind diese sehr empfindlich gegenüber mechanischen Beanspruchungen sowohl über deren Lebensdauer hinweg, als auch während deren Montage in einer Fahrzeugleuchte, welche Montage die Unterbringung und Herstellung einer die Zweitkontaktierung umfassenden oder aus dieser bestehenden elektrischen Verbindung zwischen einem von außerhalb der Fahrzeugleuchte zugänglichen Anschluss und dem per elektrischem Erstkontakt mit der OLED verbundenen Leiterbahnträger vorsieht. Darüber hinaus ist absehbar, dass OLEDs mit Deck- und Basisschichten aus Kunststoff ebenfalls nicht nach Belieben flexibel sind und damit beim Einbau ebenfalls Schäden davon tragen können.

Zur Ein- und Unterbringung von OLEDs in Leuchteninnenräumen von Fahrzeugleuchten ist daher die Verwendung vorzugsweise flexibler, mit einer oder mehreren OLEDs durch eine elektrische Erstkontaktierung elektrisch kontaktierter Leiterbahnträger angestrebt, welche die wenigen bei der Ein- und Unterbringung auftretenden Biegezyklen problemlos überstehen.

Ein weit verbreitetes Beispiel für im Gegensatz zu starren Leiterplatten flexiblen Leiterbahnträgern sind so genannte, auch als Leiterbahnflexfolien bezeichnete Flexplatinen. Flexplatinen sind biegsam, beispielsweise elastisch oder biegeschlaff verformbar ausgeführt.

Nachteilig an Flexplatinen ist, dass einerseits die elektrische Erstkontaktierung von Flexplatinen mit OLDEs nicht so einfach, unkompliziert und dadurch kostengünstig abläuft, wie dies bei starren Leiterbahnträgern der Fall ist, und dass eine mit einer OLED durch eine elektrische Erstkontaktierung verbundene Flexplatine nur mittels einer eine kostspielige, auch als indirekte Steckverbindung bezeichnete, zweiteilige Steckverbindung umfassenden elektrischen Zweitkontaktierung elektrisch weiterkontaktiert werden kann.

Die elektrische Zweitkontaktierung hat hierbei einen entscheidenden Einfluss auf die Herstellungskosten.

Eine kostengünstige elektrische Kontaktierung von als starre Leiterplatten ausgeführten Leiterbahnträgern bedient sich einer Direktsteckverbindung.

Eine Direktsteckverbindung unterscheidet sich dabei von einer indirekten Steckverbindung dadurch, dass nur ein Steckerteil erforderlich ist, das direkt beispielsweise auf einer Leiterplatte vorhandene Leiterbahnen kontaktiert. Bei einer indirekten Steckverbindung ist ein mit den Leiterbahnen beispielsweise einer Leiterplatte verbundenes Gegenstück erforderlich, welches das Steckerteil aufnimmt.

Eine Direktsteckverbindung kann beispielsweise mittels eines auch als Seitenplatinenstecker bezeichneten Randkontaktsteckers hergestellt werden.

Ein Randkontaktstecker weist ein Gehäuse auf, welches ein oder mehrere Kontaktmittel teilweise umgibt.

Die einzelnen Kontaktmittel von Randkontaktsteckern sind durch mit als Einzelleitungen oder Flachbandleitungen ausgeführten elektrischen Leitungen beispielsweise durch Löten oder Crimpen oder Schraubklemmen verbindbare Klammern gebildet, welche eine Leiterplatte umgreifen und dabei auf einer oder auf gegenüberliegenden Seiten der Leiterplatte identisch ausgeführte Leiterbahnen elektrisch kontaktieren.

Ein weit verbreitetes Beispiel von als Seitenplatinenstecker oder Randkontaktstecker für Direktsteckverbindungen einsetzbaren Steckerteilen sind RAST-Steckverbinder (RAST; Raster-Anschluss-Steck-Technik). Hierbei handelt es sich um Steckverbinder der sogenannten Hausgerätenormen RAST 2.5 und RAST 5, wobei die Ziffern den Millimeterabstand zwischen benachbarten Kontaktmitten angeben.

Die Hausgerätespezifikation RAST ist unter dem Dach des Zentralverband Elektrotechnik- und Elektronikindustrie e. V. (ZVEI) durch einen Arbeitskreis der Hersteller von Haushaltsgroßgeräten und von Steckverbindern mit dem Ziel ins Leben gerufen worden, Komponenten zu standardisieren, die Konformität der Steckverbinder verschiedener Hersteller zu gewährleisten und Fehler im Produktionsprozess aufgrund falsch zusammengesteckter Steckverbindungen auszuschließen und damit einhergehend die Montage im Zusammenbau der Endgeräte zu vereinfachen und Fehlverdrahtungen zu minimieren. RAST ermöglicht zudem die Gruppierung von Anschlüssen, wodurch der Einsatz von einzelnen Anschlüssen und individuellen Kabelbäumen vermieden werden kann. In enger Abstimmung zwischen den wichtigsten deutschen Herstellern von Hausgeräten und Steckverbindern entstand ein bis heute gängiger Standard.

Heute sind RAST-Steckverbinder längst Standard für eine Vielzahl von Sensor-, Schalter-, Aktor- und Motorsteuerleitungen, die direkt oder indirekt mit der Leiterplatte und/oder den Komponenten verbunden werden können. Die Vorteile der RAST-Stecker sind auch von anderen Branchen erkannt worden, so dass auch außerhalb der Hausgeräte eine stetig wachsende weltweite Verbreitung zu finden ist, etwa in der Heizungstechnik oder der Automobilindustrie.

Durch DE 10 2010 047 899 A1 ist ein Leuchtmittel mit mindestens einer auf einer Leiterplatte angeordneten Lichtquelle und einem lösbar mit einem Laschenbereich der Leiterplatte verbindbaren, in eine Vormontagestellung und eine Endmontagestellung bringbaren Randkontaktstecker bekannt. Der Randkontaktstecker weist durch Kontaktelemente gebildete Kontaktmittel auf, an denen elektrische Leitungen angeschlossen sind. Die Leiterplatte weist Leiterbahnen auf, die direkt oder indirekt über eine Ansteuereinrichtung mit elektrischen Anschlüssen der Lichtquelle verbunden sind. Die Leiterbahnen haben Kontaktstellen, welche die Kontaktelemente bei in Endmontagestellung befindlichem Randkontaktstecker kontaktieren.

Durch Randkontaktstecker hergestellte Direktsteckverbindungen finden jedoch bei Flexplatinen aufgrund der geringen Dicke von Flexplatinen von nur wenigen zehntel Millimetern keine Anwendung. Dies ist dadurch bedingt, dass Randkontaktstecker wegen deren Umgreifens des Rands eines Leiterbahnträgers nicht in Verbindung mit kosten- und anwendungstechnisch sehr vorteilhaften Flexplatinen eingesetzt werden können, da deren foliendünne Dickenabmessung es weder zulässt, durch Klammern gebildete Kontaktmittel von Randkontaktsteckern von einem Rand einer Flexplatine her auf eine solche aufzuschieben, ohne Gefahr zu laufen, die Flexplatine dabei zu beschädigen, noch erlaubt, eine Flexplatine zwischen zwei einander gegenüberliegende, einseitig an einer Verbindungsseite beispielsweise mittels eines Stegs vorzugsweise einstückig federelastisch miteinander elektrisch leitfähig verbundene, an der Verbindungsseite um einen vorgegebenen Abstand, der ausreicht, um eine starre Leiterplatte, bevorzugt eine starre Standard-Leiterplatte zwischen die Kontaktschwingen einzuschieben, voneinander beabstandeten Kontaktschwingen eines als Klammer ausgeführten Kontaktmittels eines Randkontaktsteckers zu klemmen und dadurch an ihren Leiterbahnen elektrisch zu kontaktieren.

Für Flexplatinen müssen deshalb bislang teure, zweiteilige, indirekte Steckverbindungen mit einem flexplatinenmontierten Stecker- oder Buchsenteil und einem leitungsseitig montierten Buchsen- oder Steckerteil verwendet werden. Beispiele für zweiteilige, indirekte Steckverbindungen sind in stehender oder liegender Ausführung flexplatinenmontierte Stiftwannen mit und ohne Rastlasche, und leitungsseitig montierte, in die Stiftwannen eingreifende Federleisten mit Crimpanschluss oder mit Schneidklemmenanschluss oder mit Schraubklemmanschluss, an die sowohl Flachbandals auch Einzelleitungen angeschlagen werden können. Die Kontaktmittel des flexplatinenmontierte Stecker- oder Buchsenteils sind mit den Leiterbahnen der Flexplatine beispielsweise durch Löten oder Crimpen elektrisch verbunden.

Im Vergleich zu Direktsteckverbindungen sind indirekte Steckverbindungen jedoch etwa um den Faktor Zwölf teurer.

So können im Vergleich zu einer zur elektrischen Kontaktierung von Flexplatinen nach dem Stand der Technik erforderlichen indirekten Steckverbindung starre Leiterplatten für etwa ein zwölftel der Kosten mittels einer per Randkontaktstecker ausgeführten Direktsteckverbindung elektrisch kontaktiert werden.

Eine aus Kostensicht in Verbindung mit einer beispielsweise in einer Fahrzeugleuchte verbauten, mittels einer Flexplatine elektrisch erstkontaktierten OLED anstrebsame Kombination aus Flexplatine und Randkontaktstecker ist demnach nach dem Stand der Technik nicht verwirklichbar. Ferner würde eine solche Kombination den weiterhin bestehenden Nachteil einer verringerten Zuverlässigkeit der vermittels Drahtbonden oder ACF-Bonding hergestellten elektrischen Erstkontaktierungen der Anschlüsse einer OLED mit den Leiterbahnen einer Flexplatine im Vergleich zu einer elektrischen Erstkontaktierungen der elektrischen Anschlüsse einer OLED mit den Leiterbahnen einer starren Leiterplatte aufweisen.

Eine Aufgabe der Erfindung ist es, eine kostengünstig herstellbare und eine sich kostensenkend auf die Herstellungskosten auswirkende geringe Ausschussquote aufweisende elektrische Kontaktierung einer OLED sowie eine mit einer entsprechenden elektrischen Kontaktierung einer OLED ausgestattete Fahrzeugleuchte zu schaffen.

Die Aufgabe wird durch die Merkmale des unabhängigen Anspruchs gelöst. Weitere vorteilhafte Ausgestaltungen werden durch die Unteransprüche beschrieben.

Ein erster Gegenstand der Erfindung betrifft demnach eine elektrische Kontaktierung wenigstens einer OLED. Die elektrische Kontaktierung umfasst eine auch als semi-flexible Leiterplatte bezeichnete starrflexible Leiterplatte mit Leiterbahnen, eine beispielsweise durch Drahtbonden oder durch ACF-Bonding vermittels Leitkleber hergestellte elektrische Erstkontaktierung der Leiterbahnen der starrflexiblen Leiterplatte mit den elektrischen Anschlüssen der mindestens einen OLED, sowie eine eine Direktsteckverbindung umfassende elektrische Zweitkontaktierung der Leiterbahnen der starrflexiblen Leiterplatte mit beispielsweise als Einzelleitungen oder zu einem Kabelbaum zusammengefassten, oder als Flachbandleitungen ausgeführten elektrischen Leitungen, welche der Weiterkontaktierung der mindestens einen OLED dienen.

Bei einem Leitkleber handelt es sich um einen elektrisch leitfähigen Klebstoff.

Leitkleber bestehen aus den Klebmittel und anorganischen, elektrisch leitfähigen Füllstoffen. Deren Anteil liegt bei etwa 30 %. Wegen der verwendeten metallischen Füllstoffe sind die Verbindungsstellen auch thermisch gut leitfähig. Zu den gut geeigneten Füllstoffen zählen Silber, Gold, Palladium, Nickel und Platin.

Eine eigene Klasse unter den Leitklebern bilden so genannte anisotrope Leitkleber. Als Füllmaterial werden kugelförmige leitende Teilchen eingesetzt. Das Gesamtvolumen wird nur zu 5 % durch das leitfähige Material gebildet. Dadurch wird eine lokal begrenzte elektrische Verbindung erreicht. Bei einem Auftrag als dünner Film wird die elektrische Verbindung nur vertikal zwischen den miteinander verklebten Oberflächen, aber nicht horizontal aufgebaut, da sich die Kugeln nicht berühren. Das gestattet den großflächigen Auftrag des Klebers ohne Justage. Nachteilig ist die Begrenzung der Betriebstemperatur auf etwa 80° Celsius und eine prinzipbedingte implizierte Kurzschlusswahrscheinlichkeit.

Eine Verbindung mit einem Leitkleber ist zwar weniger leitfähig als eine Lötverbindung, ist aber elastisch und dadurch mechanisch belastbarer. Eine hohe Elastizität erreichen beispielsweise Silikonkleber.

Die starrflexible Leiterplatte besteht aus elektrisch isolierendem Material mit daran haftenden, als Leiterbahnen dienenden, elektrisch leitenden Verbindungen. Die Leiterbahnen werden vorzugsweise aus einer dünnen Schicht Kupfer geätzt. Als isolierendes Material wird faserverstärkter Kunststoff bevorzugt. Meistgenutztes und daher bevorzugt vorgesehenes isolierendes Material im Anwendungsbereich von Leiterplatten ist FR-4.

FR-4 oder auch FR4 bezeichnet eine Klasse von schwer entflammbaren und flammenhemmenden Verbundwerkstoffen bestehend aus Epoxidharz und Glasfasergewebe. Die Abkürzung FR steht für flame retardant (flammenhemmend) und entspricht den Anforderung von UL94V-0. FR-4 ist in verschiedenen Varianten verfügbar. Zur Verbesserung der Flammhemmung wird der Verbundwerkstoff mit chemischen Stoffen wie polybromierte Diphenylether basierend auf Brom versetzt, in der halogenfreien Variante entfällt dieser Zusatz. Der Verbundwerkstoff FR-4 wurde 1968, neben anderen Verbundwerkstoffen, von der National Electrical Manufacturers Association (NEMA) in den Eigenschaften in der Spezifikation NEMA L11 festgelegt.

FR-4 weist im Gegensatz zu ähnlichen Verbundwerkstoffen wie FR-2, sogenanntes Hartpapier, eine bessere Kriechstromfestigkeit und eine geringere Wasseraufnahme auf. Weiterer Vorteil von FR-4 ist die gute Haftbarkeit, welche das dauerhafte Anbringen von Leiterbahnstrukturen aus Kupfer auf dem Trägermaterial gewährleistet.

Leiterplatten mit FR-4 als elektrisch isolierendem Material werden gängig und daher nachfolgend als FR-4 Platinen bezeichnet.

Bei einer starrflexiblen Leiterplatte, beispielsweise einer starrflexiblen FR-4 Platine, ist in wenigstens einem ersten Abschnitt das elektrisch isolierende Material von der den Leiterbahnen gegenüberliegenden Unterseite der eben daliegenden Leiterplatte her gesehen zwischen zwei parallel zu der mit den Leiterbahnen versehenen Oberseite verlaufenden, einander im Bereich der starrflexiblen Leiterplatte nicht schneidender Geraden zumindest teilweise, höchstens jedoch bis zur durch die als Leiterbahnen dienenden, elektrisch leitenden Verbindungen gebildeten Leiterbahnebene ausgespart.

Die Aussparung kann im Herstellungsprozess der starrflexiblen Leiterplatte vorgesehen werden, oder die starrflexible Leiterplatte kann aus einer starren Leiterplatte hergestellt werden, beispielsweise idem das elektrisch isolierende Material im ersten Abschnitt durch Tiefenfräsen entfernt wird.

Hierdurch ist eine starrflexible Leiterplatte in dem mindestens einen ersten Abschnitt stark verjüngt, was der starrflexiblen Leiterplatte in dem mindestens einen ersten Abschnitt eine beispielsweise zum Einbau in begrenzte Bauräume vorteilhafte beispielsweise elastisch reversible, anelastisch plastische oder biegeschlaffe Biegsamkeit verschafft.

Wenigstens in einem zweiten Abschnitt ist das elektrisch isolierende Material nach wie vor vorhanden, was der starrflexiblen Leiterplatte in dem mindestens einen zweiten Abschnitt eine zur Verwendung in Verbindung mit einer beispielsweise durch einen oder mehrere Randkontaktstecker gebildeten Direktsteckverbindung erforderliche Stabilität verschafft.

Die starrflexible Leiterplatte kann mehrere, beispielsweise zwei, zweite Abschnitte aufweisen, zumindest zwischen denen jeweils ein erster Abschnitt angeordnet ist.

Die elektrische Kontaktierung umfasst wie bereits erwähnt wenigstens eine OLED, die durch Drahtbonden oder durch ACF-Bonding vermittels Leitkleber mit den Leiterbahnen eines ersten oder zweiten Abschnitts der starrflexiblen Leiterplatte elektrisch erstkontaktiert ist.

Die elektrische Kontaktierung umfasst ferner mindestens eine von einem Rand her auf einen von dem mit seinen Leiterbahnen von der OLED erstkontaktierten Abschnitt verschiedenen zweiten Abschnitt der starrflexiblen Leiterplatte her unter Herstellung der elektrischen Zweitkontaktierung dienenden elektrischen Kontakts jedes ihrer mit jeweils einer der Weiterkontaktierung dienenden elektrischen Leitung elektrisch verbundenen Kontaktmittel mit einer in dem entsprechenden Abschnitt eine Kontaktfläche bildenden Leiterbahn der starrflexiblen Leiterplatte aufschiebbaren oder aufgeschobenen Direktsteckverbindung, beispielsweise in Form wenigstens eines Randkontaktsteckers.

Die mindestens eine OLED ist demnach durch Drahtbonden oder durch ACF-Bonding vermittels Leitkleber an einem anderen, als dem zweiten Abschnitt, von dessen Rand her mindestens ein Randkontaktstecker unter Herstellung elektrischen Kontakts jedes seiner mit jeweils einer elektrischen Leitung elektrisch verbundenen Kontaktmittel mit einer eine Kontaktfläche aufweisenden oder bildenden Leiterbahn der starrflexiblen Leiterplatte aufschiebbar oder aufgeschobenen ist, mit den Leiterbahnen der starrflexiblen Leiterplatte erstkontaktiert.

Dadurch, dass die starrflexible Leiterplatte in dem mindestens einen ersten Abschnitt stark verjüngt ist, ist zum Einbau und zur Anordnung einer oder mehrerer mit den Leiterbahnen der starrflexiblen Leiterplatte elektrisch und mechanisch verbundener OLEDs beispielsweise in einen Leuchteninnenraum eine ausreichende Flexibilität gewährleistet. Gleichzeitig kann die elektrische Kontaktierung zwischen der beispielsweise als tiefengefräste FR-4 Platine ausgeführten starrflexiblen Leiterplatte und OLED auf einfache und gewohnte Art und Weise beispielsweise durch Draht-Bonden oder ACF-Bonden hergestellt werden, ohne dass undefinierte Lage und Ausrichtung Einfluss auf den Herstellungsprozess nehmen, wie dies bei Flexplatinen gerne der Fall ist.

Die jeweils mit einem der Kontaktmittel der mindestens einen Direktsteckverbindung elektrisch verbundenen, der Weiterkontaktierung beispielsweise innerhalb einer Fahrzeugleuchte dienenden Leitungen können beispielsweise zu einem Kabelbaum zusammengefasst als Einzelleitungen oder Flachbandleitungen ausgeführt sein.

Wichtig ist hervorzuheben, dass die Erfindung ebenfalls verwirklicht sein kann durch eine Reihe von vermittels starrflexibler Leiterplatten, beispielsweise tiefengefräster FR-4 Platinen, elektrisch kontaktierter OLEDs, die untereinander ohne zusätzliche Steckverbindung elektrisch kontaktiert werden, indem immer via Direktsteckverbindung eine mit einer OLED elektrisch kontaktierte starrflexible Leiterplatte, beispielsweise eine tiefengefräste FR-4 Platine, mit einer anderen, ebenfalls mit einer OLED elektrisch kontaktierten starrflexiblen Leiterplatte, beispielsweise tiefengefrästen FR-4 Platine elektrisch verbunden wird.

Hierdurch lassen sich Leitungsverbindungen zwischen als OLEDs ausgeführten Lichtquellen von Leuchtmitteln in Fahrzeugleuchten ganz einsparen.

Die Direktsteckverbindung der elektrischen Kontaktierung kann beispielsweise einen Randkontaktstecker mit einer Anzahl von Kontaktmitteln umfassen, welche Anzahl beispielsweise zumindest einer Zahl von beispielsweise zum Betrieb wenigstens einer durch ein oder mehrere via der auf der starrflexiblen Leiterplatte ausgebildeten Leiterbahnen elektrisch kontaktierte, beispielsweise untereinander elektrisch verbundene Elektronikbauteile gebildeten Einrichtung erforderlichen, jeweils durch mindestens eine Kontaktfläche gebildeten elektrischen Anschlüssen der starrflexiblen Leiterplatte entspricht.

Bei der Einrichtung kann es sich beispielsweise um eine Elektronikschaltung handeln, die beispielsweise wenigstens einen Teil, etwa eine Ansteuereinrichtung, eines eine oder mehrere Lichtquellen umfassenden Leuchtmittels einer Fahrzeugleuchte umfassen kann. Alternativ oder zusätzlich kann die Einrichtung eine oder mehrere Lichtquellen eines Leuchtmittels einer Fahrzeugleuchte umfassen.

Zum Betrieb von OLEDs als Lichtquellen für ein Leuchtmittel beispielsweise einer Fahrzeugleuchte können eine oder mehrere mehr oder minder komplexe Elektronikschaltungen vorgesehen sein, die beispielsweise auf einem oder mehreren Leuchtmittelträgern des Leuchtmittels angeordnet und in dem Leuchteninnenraum beherbergt sein können.

Ein einfaches Beispiel für eine Elektronikschaltung betrifft die Angleichung unterschiedlicher Helligkeiten einzelner OLEDs oder von OLED-Strängen innerhalb einer Gruppe gemeinsam betriebener, vermittels einer oder mehrerer sich starrflexibler Leiterplatten bedienender elektrischer Kontaktierungen kontaktierter OLEDs. Eine solche Elektronikschaltung kann aus mindestens einem oder mehreren Vorwiderständen zur Anpassung der Vorwärtsspannung der OLEDs an das Bordnetz bestehen. Beispielsweise ist bekannt, OLEDs ähnlich wie LEDs im so genannten Binning nach Vorwärtsspannung und Intensität zu sortieren. Um Unterschiede zwischen mehreren OLED-Strängen auszugleichen, die jeweils aus in Reihe geschalteten OLEDs gleicher Vorwärtsspannung und Intensität bestehen, und um eine homogene Helligkeitsverteilung der benachbarten OLED-Stränge aus OLEDs mit unterschiedlicher Vorwärtsspannung und Intensität zu erhalten, wird zumindest jeder OLED-Strang mit einem anderen Vorwiderstand versehen.

OLDEs bedürfen darüber hinaus beim Einsatz als Lichtquelle insbesondere in Fahrzeugleuchten oft einer separaten Ausfallerkennung. Dies ist bedingt durch die geringe Leistungsaufnahme von OLEDs im Allgemeinen. Beispielsweise ist ein in einem Fahrzeug untergebrachtes Steuergerät nicht in der Lage, eine dem Ausfall einer oder weniger OLEDs entsprechende Änderung der Leistungsentnahme aus dem Bordnetz zumindest ohne weiteres mit ausreichender Zuverlässigkeit zu erkennen, da eine hieraus resultierende Bordnetzspannungsänderung unterhalb der im normalen Betrieb eines Fahrzeugs auftretenden Bordnetzspannungssschwankungen liegt. Eine beispielsweise in der Fahrzeugleuchte untergebrachte elektronische Schaltungsanordnung zur Ausfallerkennung erfasst den Ausfall einer oder mehrerer Leuchtdioden in der Fahrzeugleuchte z.B. mittels eines oder mehrerer Komparatoren und teilt dies dem Steuergerät mit. Daraufhin erkennt das Steuergerät, dass die Stromaufnahme der Leuchtenfunktion unter einen bestimmten Wert fällt und schaltet daraufhin die Leuchtenfunktion ganz ab und meldet es -falls im Fahrzeug vorgesehen- dem Fahrer dies mittels einer Anzeigeeinrichtung. Diese elektronische Schaltungsanordnung zur Ausfallerkennung kann durch eine durch ein oder mehrere beispielsweise auf der starrflexiblen Leiterplatte aufgebrachte Elektronikbauteile gebildete Elektronikschaltung verwirklicht sein.

Darüber hinaus können OLEDs weiterer Elektronikschaltungen bedürfen. Beispiele hierfür sind Elektronikschaltungen:
- zur Regelung und/oder Steuerung der Helligkeit bzw. Leuchtdichte bzw. Leuchtkraft der OLEDs, beispielsweise durch eine pulsweitenmodulierte Taktung der Stromversorgung für einen vorzugsweise außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der OLEDs z.B. vor einer Überspannung des Bordnetzes oder vor fehlerhafter Polung, beispielsweise umfassend eine oder mehrere Zenerdioden,

Zusammengefasst kann für fast alle OLED-Anwendungen eine mehr oder minder umfangreiche, für die speziellen OLEDs ausgelegte Elektronikschaltung vorgesehen werden. Die Elektronikschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit kann ein eine oder mehrere zuvor beschriebene elektrische Kontaktierungen umfassendes Leuchtmittel mit einer oder mehreren OLEDs als Lichtquelle meist zusätzlich zu einer oder mehreren aufgrund ihres Diodenaufbaus selbst Elektronikbauteile darstellenden OLEDs zumindest ein weiteres zuvor genanntes Elektronikbauteil aufweisen. Demnach kann ein Leuchtmittel mit einer oder mehreren OLEDs als Lichtquellen neben der mindestens einen OLED zumindest noch über ein weiteres Elektronikbauteil verfügen. Das zumindest eine Elektronikbauteil und/oder eine hierdurch gebildete Elektronikschaltung kann auf der starrflexiblen Leiterplatte angeordnet sein.

Ein entsprechendes, eine oder mehrere zuvor beschriebene elektrische Kontaktierungen umfassendes Leuchtmittel kann zusätzlich zu der mindestens einen OLED eine oder mehrere zusätzliche Lichtquellen umfassen, beispielsweise eine oder mehrere LEDs. Diese können wie OLEDs auch zu deren Betrieb einer Elektronikschaltung aus mehreren Elektronikbauteilen bedürfen. Eine solche Elektronikschaltung kann alternativ oder zusätzlich auf der starrflexiblen Leiterplatte ausgebildet sein.

Mindestens eine zur Erfüllung wenigstens einer Lichtfunktion beispielsweise einer Fahrzeugleuchte vorgesehene Lichtquelle kann als mindestens ein Elektronikbauteil oder zusätzlich zu einem oder mehreren Elektronikbauteilen vermittels zumindest eines Teils der Leiterbahnen der starrflexiblen Leiterplatte elektrisch kontaktiert, beispielsweise auf einem oder mehreren Abschnitten der starrflexiblen Leiterplatte vorgesehen sein. Die vermittels der elektrischen Erstkontaktierung mit den elektrischen Anschlüssen wenigstens einer OLED verbundenen Leiterbahnen der starrflexiblen Leiterplatte können somit direkt oder indirekt über eine Elektronikschaltung mit den als elektrische Anschlüsse für die elektrische Zweitkontaktierung dienenden Kontaktflächen verbunden sein.

Die starrflexible Leiterplatte kann Pads und/oder Lötaugen zur elektrischen und mechanischen Befestigung eines oder mehrerer Elektronikbauteile aufweisen.

Die elektrische Kontaktierung und Befestigung von Elektronikbauteilen auf der starrflexiblen Leiterplatte kann erfolgen, indem die Elektronikbauteile in Oberflächenmontage-Technik (SMD-Technik; Surface Mounted Device) auf als Lötflächen (Pads) ausgebildete Partien der Leiterbahnen der starrflexiblen Leiterplatte oder in Durchsteckmontage-Technik (THT-Technik; Through Hole Technology) in als Lötaugen ausgebildete Partien der Leiterbahnen der starrflexiblen Leiterplatte gelötet werden. So werden sie an diesen footprints gleichzeitig mechanisch gehalten und elektrisch verbunden. Größere Elektronikbauteile können auch mit Kabelbindern, Klebstoff oder Verschraubungen auf dem entsprechenden Abschnitt der starrflexiblen Leiterplatte befestigt werden.

Aus prozesstechnischer Sicht bietet sich an, Elektronikbauteile bevorzugt auf einem oder mehreren zweiten Abschnitten der starrflexiblen Leiterplatte anzuordnen.

Der Randkontaktstecker kann ein Gehäuse aufweisen, welches das eine oder die mehreren Kontaktmittel teilweise umgibt.

Jedes der Kontaktmittel des Randkontaktsteckers kann eine Klammer umfassen. Jede Klammer kann mit zwei einander gegenüberliegenden, einseitig an einer Verbindungsseite beispielsweise mittels eines Stegs vorzugsweise einstückig in dem Sinne federelastisch miteinander elektrisch leitfähig verbundenen Kontaktschwingen ausgeführt sein, dass die freien Enden der Kontaktschwingen einer Klammer in einem Ausgangszustand aneinander anliegen oder um einen geringen Abstand von beispielsweise nur wenigen zehntel Millimetern einander gegenüberliegend voneinander beabstandet sind, und unter Überwindung der Federbelastung voneinander weg ausgelenkt werden können. Die Kontaktschwingen sind an der Verbindungsseite um einen vorgegebenen Abstand voneinander beabstandet, der vorzugsweise ausreicht, um eine Leiterplatte, bevorzugt eine Standard-Leiterplatte, besonders bevorzugt eine FR-4 Platine, zwischen die Kontaktschwingen einzuschieben.

Dadurch kann der mindestens eine zweite Abschnitt der starrflexiblen Leiterplatte wie eine Standard-Leiterplatte ausgeführt sein. Dies vereinfacht die Herstellung der starrflexiblen Leiterplatte beispielsweise durch Tiefenfräsen.

Zumindest in einem Bereich an den von der Verbindungsseite beabstandeten freien Enden der Kontaktschwingen herrscht wie zuvor beschrieben ein geringerer Abstand, so dass ein zwischen die Kontaktschwingen der einen oder mehreren als Kontaktmittel des Randkontaktsteckers dienenden Klammern eingeschobener zweiter Abschnitt der starrflexiblen Leiterplatte zumindest im Bereich deren freier Enden federelastisch eingeklemmt wird. Dabei ist von den freien Enden her kommend vorzugsweise eine Aufweitung vorgesehen, um das Einschieben eines zweiten Abschnitts der starrflexiblen Leiterplatte zwischen die Kontaktschwingen zu erleichtern.

An den Kontaktmitteln sind beispielsweise zu einem Kabelbaum zusammengefasste elektrische Leitungen angeschlossen oder anschließbar.

Die elektrische Kontaktierung ist beispielsweise durch eine Vorrichtung verwirklicht, welche:
- eine starrflexible Leiterplatte bestehend aus einem elektrisch isolierenden Material und auf dieses aufgebrachten Leiterbahnen, wobei in wenigstens einem ersten Abschnitt das elektrisch isolierende Material über die gesamte Breite der starrflexiblen Leiterplatte wenigstens zwischen zwei parallel zu der mit den Leiterbahnen versehenen Oberseite verlaufender, einander im Bereich der starrflexiblen Leiterplatte nicht schneidender Geraden von einer den Leiterbahnen abgewandten Unterseite der starrflexiblen Leiterplatte her zumindest zum Teil ausgespart ist, wohingegen in wenigstens einem sich an eine der Geraden anschließenden zweiten Abschnitt das elektrisch isolierende Material frei von einer Aussparung oder zumindest nur mit loch- oder sacklochförmigen Aussparungen, beispielsweise zur mechanischen Befestigung oder THT-Montage von Elektronikbauteilen ausgeführt ist, wobei zumindest ein Teil der Leiterbahnen in wenigstens einem zweiten Abschnitt einer elektrischen Zweitkontaktierung dienende Kontaktflächen aufweisen,
- mindestens eine OLED, deren elektrische Anschlüsse vermittels einer elektrischen Erstkontaktierung mit Leiterbahnen der starrflexiblen Leiterplatte elektrisch verbunden sind, und
- mindestens eine eine elektrische Zweitkontaktierung bildende Direktsteckverbindung mit Kontaktmitteln, welche mit der Weiterkontaktierung beispielsweise innerhalb einer Fahrzeugleuchte dienenden elektrischen Leitungen elektrisch verbunden sind, und welche von einem Rand wenigstens eines mit Kontaktflächen ausgeführten zweiten, jedoch von dem mit seinen Leiterbahnen von der mindestens einen OLED erstkontaktierten Abschnitt verschiedenen Abschnitts her auf die starrflexible Leiterplatte aufgeschoben einen elektrischen Kontakt mit je mindestens einer Kontaktfläche herstellen,
umfasst. Dadurch ist die Erstkontaktierung biegsam gegenüber der Zweitkontaktierung angeordnet.

Die Vorrichtung kann einzelne oder Kombinationen der zuvor und/oder nachfolgend zur elektrischen Kontaktierung beschriebenen Merkmale aufweisen.

Es ist ersichtlich, dass die Erfindung demnach verwirklicht sein kann durch eine Vorrichtung umfassend eine durch eine elektrische Erstkontaktierung, beispielsweise durch Drahtbonden oder durch ACF-Bonding vermittels Leitkleber, mit ihren elektrischen Anschlüssen mit den Leiterbahnen einer starrflexiblen Leiterplatte elektrisch verbundene OLED, welche Leiterbahnen der starrflexiblen Leiterplatte vermittels einer durch eine lösbare oder unlösbare Direktsteckverbindung hergestellten elektrischen Zweitkontaktierung mit beispielsweise zu einem Kabelbaum zusammengefassten elektrischen Leitungen elektrisch verbunden sind. Bei der starrflexiblen Leiterplatte kann es sich um eine kurz als Leiterkarte, Platine oder PCB bezeichnete, starre Leiterplatte handeln, welche durch Tiefenfräsen oder durch Aussparung des elektrisch isolierenden Materials bereits während ihrer Herstellung in mindestens zwei miteinander wenigstens via Leiterbahnen verbundene Abschnitte unterteilt ist. Durch das Aussparen oder Tiefenfräsen ist hierbei wenigstens ein Teil des elektrisch isolierenden Materials der starrflexiblen Leiterplatte in wenigstens einem ersten Abschnitt zumindest so weit nicht vorhanden oder entfernt, dass der erste Abschnitt biegsam ist. Der verbleibende, nicht ausgesparte oder durch das Tiefenfräsen nicht entfernte Teil der starrflexiblen Leiterplatte in dem ersten Abschnitt umfasst wenigstens die Leiterbahnen. Ein erster Abschnitt kann so beispielsweise eine gelenkige Verbindung zwischen zwei starren, zweiten Abschnitten bilden.

Die elektrische Kontaktierung kann alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Anwendungsbeispiele der Erfindung finden sich beispielsweise bei der elektrischen Kontaktierung von OLEDs von einem Kabelsatz für interne Leuchtenkontaktierung.

Zusätzliche, über die Lösung der gestellten Aufgabe und/oder über die voran zu den einzelnen Merkmalen genannten Vorteile hinausgehende Vorteile gegenüber dem Stand der Technik sind nachfolgend aufgeführt.

Die Erfindung ermöglicht eine Verbesserung und Vereinfachung der elektrischen Kontaktierung von OLEDs in Fahrzeugleuchten. Es wird eine Kontaktierungsmöglichkeit von OLEDs vermittels starrflexibler Leiterplatte, beispielsweise tiefengefräster FR-4 Platinen geschaffen. Diese können kostengünstig auf bekannte Art und Weise mit OLEDs elektrisch kontaktiert werden und darüber hinaus mittels Direktsteckverbindern weiter kontaktiert werden. Die beispielsweise durch Tiefenfräsen hergestellte Aussparung bietet die zum Einbau der OLED in den Leuchteninnenraum notwendige Flexibilität.

Die mit einer OLED elektrisch verbundene, starrflexible Leiterplatte, beispielsweise tiefengefräste FR-4 Platine, kann einfach vermittels einer Direktsteckverbindung beispielsweise vermittels eines Randkontaktsteckers weiterkontaktiert werden, wobei Direktsteckverbindungen mindestens um den Faktor zwölf günstiger sind, als indirekte, zwei- oder mehrteilige Steckverbindungen.

Hierdurch können z. B. bei der Kontaktierung von OLEDs in Fahrzeugleuchten Kosten, Teile und Ressourcen gespart werden. Die sonst nötigen Verkabelungskonzepte werden signifikant vereinfacht, wodurch auch in der Produktion und Montage Ressourcen wie Zeit und Kosten eingespart werden können.

Mit der Erfindung lassen sich OLEDs an semi-flexible Leiterplatten und diese wiederum mit Direktsteckverbinder - zum Beispiel Randkontaktstecker - kontaktieren.

Die Kontaktierung an den OLEDs ist möglich, da die Leiterplattendicke im beispielsweise zur Erstkontaktierung der OLED verwendeten ersten Abschnitt nur wenige zehntel Millimeter, beispielsweise 0,2mm beträgt und weiterhin auch für den Einbau in die Leuchtenumgebung eine gewisse Biegbarkeit aufweist.

Ein Direktsteckverbinder benötigt eine bestimmte Dicke und Steifigkeit der Platinen, damit dieser zuverlässig aufgesteckt werden kann und hält. Dies ist durch den zweiten Abschnitt der starrflexiblen Leiterplatte gegeben.

Weiterhin ist es möglich direkt an der OLED Elektronikbauteile anzubringen, die auch wärmetechnisch vorteilhaft auf dem zweiten Abschnitt der starrflexiblen Leiterplatte sitzen. Auch sind die Ansteuerungswege über die kurzen Kontaktierungsleitungen kurz, was sich positiv auf die elektromagnetische Verträglichkeit (EMV) der Anordnung auswirkt. So werden durch die kurzen Leitungen weniger Störstrahlungen eingefangen und auch weniger ausgesendet, wohingegen sich lange Leitungen wie relativ große Antennen verhalten.

### Ein zweiter Gegenstand der Erfindung betrifft eine mit einer entsprechend elektrisch kontaktierten OLED ausgestattete Fahrzeugleuchte

Eine Fahrzeugleuchte umfasst im Wesentlichen einen von einem Leuchtengehäuse und einer Lichtscheibe umschlossenen Leuchteninnenraum und mindestens ein darin beherbergtes Leuchtmittel mit zumindest einer Lichtquelle, sowie gegebenenfalls zugehörige Elektronikbauteile für wenigstens eine Lichtfunktion der Kraftfahrzeugleuchte. In dem Leuchteninnenraum kann mindestens ein von außerhalb des Leuchteninnenraums durch eine oder mehrere von der Lichtscheibe verschlossene Lichtöffnungen hindurch gesehen hinter wenigstens einer Lichtquelle des zumindest einen Leuchtmittels angeordneter Reflektor untergebracht sein. Der Reflektor kann zumindest zum Teil durch ein separates Bauteil und/oder durch wenigstens einen Teil des Leuchtengehäuse selbst, beispielsweise vermittels einer zumindest teilweisen reflektierenden Beschichtung, gebildet sein.

Wenigstens einer Lichtquelle des Leuchtmittels können ein oder mehrere Optikelemente, wie etwa mindestens eine Linse, mindestens ein Rinnenkonzentrator, z.B. mindestens eine Parabolrinne (CPC; Compound Parabolic Concentrator) oder dergleichen zur Ausformung einer definierten Abstrahlcharakteristik zugeordnet sein.

Die Lichtscheibe ist durch eine transparente Abdeckung gebildet, welche den Leuchteninnenraum sowie die von diesem beherbergten Bauteile gegen Witterungseinflüsse schützt.

In dem Leuchteninnenraum kann im Strahlengang zwischen wenigstens einer Lichtquelle des Leuchtmittels und der Lichtscheibe wenigstens eine Optikscheibe angeordnet sein, welche beispielsweise eine bestimmte Struktur und/oder Maskierung aufweisen kann, etwa um bei einer klaren, beispielsweise für einen Betrachter eine Tiefenwirkung bewirkenden Lichtscheibe das Leuchtmittel und/oder dessen mindestens eine Lichtquelle zu kaschieren. Das Leuchtengehäuse bzw. der Leuchteninnenraum kann in mehrere Leuchtenkammern mit jeweils eigenen Lichtquellen und/oder Leuchtmitteln, eventuell Reflektoren und/oder Optikelementen und/oder Optikscheiben, sowie gegebenenfalls Lichtscheiben unterteilt sein, von denen mehrere oder alle Leuchtenkammern gleiche oder jede Leuchtenkammer eine andere Lichtfunktionen erfüllen kann.

Bei einer Lichtfunktion handelt es sich dabei um eine durch Abstrahlung von Licht einer bestimmten Farbe in einer bestimmten Helligkeit und Richtung verwirklichte, zur Erfüllung einer Aufgabe vorgesehene Funktion der Fahrzeugleuchte. Jede Fahrzeugleuchte erfüllt je nach Ausgestaltung eine oder mehrere Aufgaben bzw. Funktionen. Zur Erfüllung jeder Aufgabe bzw. Funktion ist eine Lichtfunktion der Fahrzeugleuchte vorgesehen. Lichtfunktionen sind beispielsweise bei einer Ausgestaltung als Scheinwerfer eine die Fahrbahn ausleuchtende Funktion, oder bei einer Ausgestaltung als Signalleuchte speziell bei Kraftfahrzeugen eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer auch als Schlusslichtfunktion bezeichneten Rücklichtfunktion, zur Sicherstellung einer Sichtbarkeit des Fahrzeugs bei Tag und/oder Nacht, wie etwa bei einer Ausgestaltung als Heckleuchte oder Tagfahrleuchte. Beispiele für Fahrzeugleuchten im Automobilbereich sind am Fahrzeugbug, an den Fahrzeugflanken und/oder an den Seitenspiegeln sowie am Fahrzeugheck angeordnete Wiederholblinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Ein Leuchtmittel für wenigstens eine Lichtfunktion umfasst zumindest wenigstens eine OLED gemäß einer zuvor beschriebenen elektrischen Kontaktierung.

### Die Fahrzeugleuchte ist bevorzugt als eine Heckleuchte ausgeführt.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die erfindungsgemäße Steckverbindung ausgestaltet sein kann und stellen keine abschließende Begrenzung dar. Es zeigen in schematischer Darstellung:
- Fig. 1: eine elektrische Kontaktierung einer OLED in perspektivischer Ansicht.
- Fig. 2: die elektrische Kontaktierung aus Fig. 1 in einer Seitenansicht.
- Fig. 3: die elektrische Kontaktierung aus Fig. 1 in einer Draufsicht.
- Fig. 4: die elektrische Kontaktierung aus Fig. 1 in einer perspektivischen Ansicht mit Blick auf die mit Leiterbahnen versehene Oberseite der starrflexiblen Leiterplatte.
- Fig. 5: die elektrische Kontaktierung aus Fig. 1 in einer perspektivischen Ansicht mit Blick auf die der mit Leiterbahnen versehenen Oberseite abgewandte und mit einer Aussparung ihres elektrisch isolierenden Materials versehene Unterseite der starrflexiblen Leiterplatte.
- Fig. 6: eine Detailansicht der elektrischen Erstkontaktierung und eines Teils der elektrischen Zweitkontaktierung der elektrischen Kontaktierung aus Fig. 1 in einer Seitenansicht.

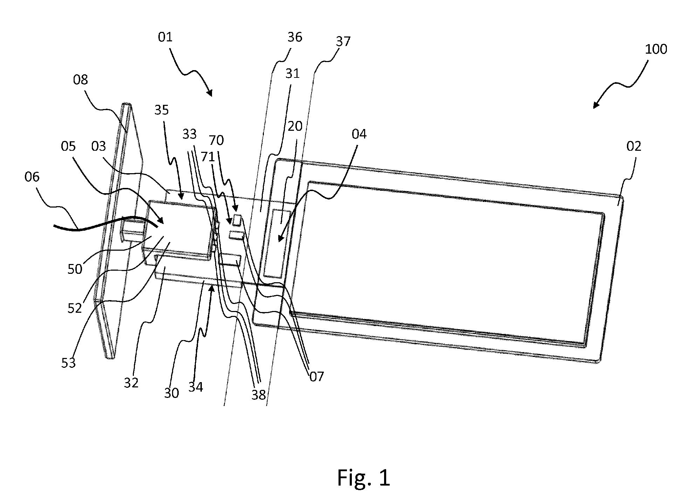

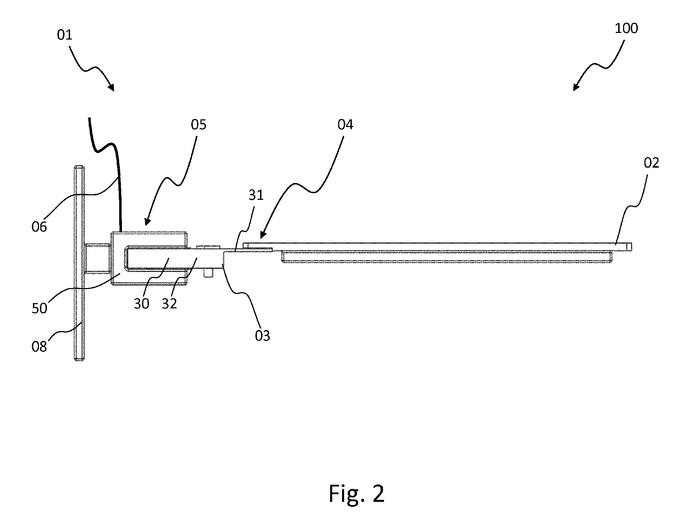

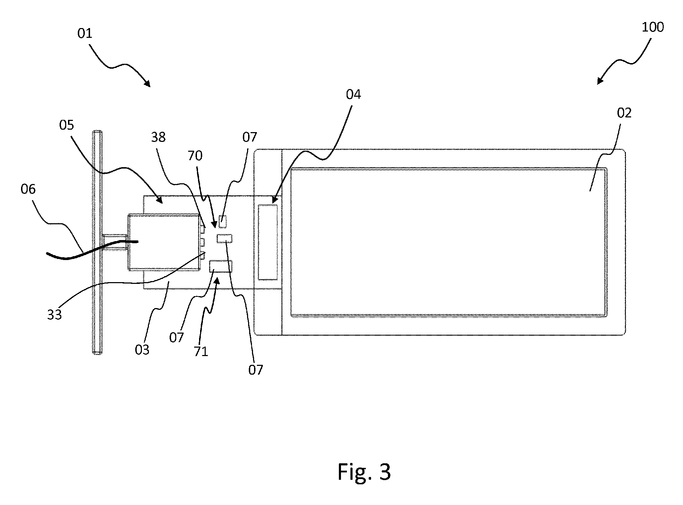

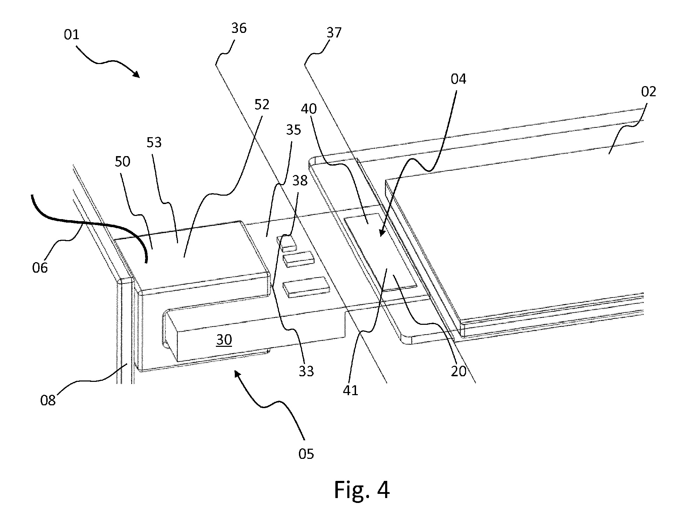

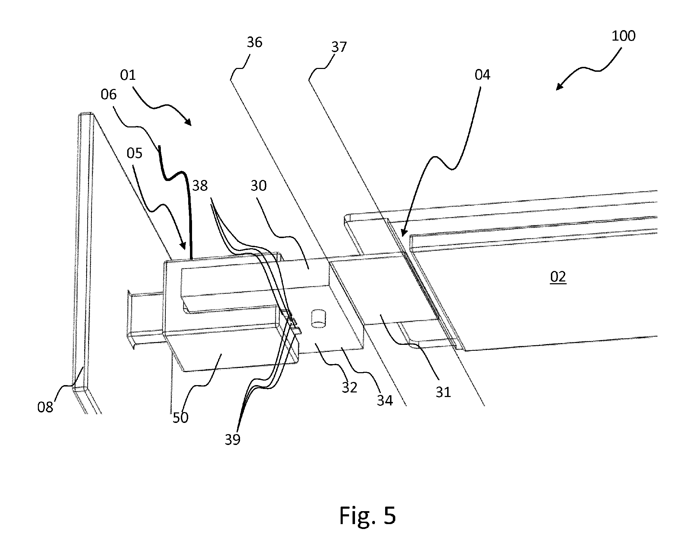

Eine in Fig. 1, Fig. 2, Fig. 3, Fig. 4, Fig. 5, Fig. 6 ganz oder in Teilen dargestellte Vorrichtung 100 umfasst eine elektrische Kontaktierung 01 mindestens einer OLED 02 mit:
- mindestens einer wenigstens einen ersten Abschnitt 31 und zumindest einen zweiten Abschnitt 32 aufweisende, auch als semi-flexible Leiterplatte bezeichnete, starrflexiblen Leiterplatte 03,
- eine elektrische Erstkontaktierung 04 der mindestens einen OLED 02, und
- eine elektrische Zweitkontaktierung 05 der mindestens einen OLED 02.

Die starrflexible Leiterplatte 03 besteht aus elektrisch isolierendem Material 30 mit daran haftenden Leiterbahnen 33, 39.

Die Leiterbahnen 33, 39 können aus einer dünnen Schicht Kupfer geätzt sein.

Als elektrisch isolierendes Material 30 kann vorteilhaft faserverstärkter Kunststoff vorgesehen sein. Insbesondere ist als elektrisch isolierendes Material 30 FR-4 vorteilhaft.

In dem zumindest einen ersten Abschnitt 31 ist das elektrisch isolierende Material 30 von der den Leiterbahnen 33 gegenüberliegenden Unterseite 34 der starrflexiblen Leiterplatte 03 her gesehen zwischen zwei parallel zu der mit den Leiterbahnen 33 versehenen Oberseite 35 verlaufenden, einander im Bereich der starrflexiblen Leiterplatte 03 vorzugsweise nicht schneidender Geraden 36, 37 zumindest teilweise, höchstens jedoch bis zur durch die Leiterbahnen 33 gebildeten Leiterbahnebene ausgespart.

Die Geraden 36, 37 können parallel zueinander verlaufen.

Demgegenüber ist der wenigstens eine zweite Abschnitt 32 frei von einer solchen Aussparung. Ferner sind zumindest ein Teil der Leiterbahnen 33 in wenigstens einem zweiten Abschnitt 32 der starrflexiblen Leiterplatte 03 zu Kontaktflächen 38 ausgebildet.

Eine der Geraden 36, 37 kann entlang eines Rands der starrflexiblen Leiterplatte 03 verlaufen. Die starrflexible Leiterplatte 03 endet hierbei am entsprechenden Rand mit einem ersten Abschnitt 31. Der Fall tritt beispielsweise dann ein, wenn die starrflexible Leiterplatte 03 wie in Fig. 1, Fig. 2, Fig. 3, Fig. 4, Fig. 5, Fig. 6 dargestellt lediglich einen ersten Abschnitt 31 und einen zweiten Abschnitt 32 aufweist.

Die Aussparung des elektrisch isolierenden Materials 30 im ersten Abschnitt 31 kann im Herstellungsprozess der starrflexiblen Leiterplatte 03 vorgesehen werden. Alternativ kann die Aussparung des elektrisch isolierenden Materials 30 vorgesehen werden, indem die starrflexible Leiterplatte 03 aus einer starren Leiterplatte hergestellt wird, wobei das elektrisch isolierende Material 30 im ersten Abschnitt 31 durch Tiefenfräsen entfernt wird.

Die elektrische Erstkontaktierung 04 umfasst beispielsweise durch Drahtbonden oder durch ACF-Bonding vermittels Leitkleber 41 hergestellte elektrisch leitfähige Verbindungen 40 zwischen je einem elektrischen Anschluss 20 der OLED 02 und je einer Leiterbahn 33 der starrflexiblen Leiterplatte 03.

Die elektrische Zweitkontaktierung 05 umfasst mindestens eine Direktsteckverbindung 50 zwischen mit der Weiterkontaktierung der mindestens einen OLED 02 dienenden, beispielsweise als Einzelleitungen oder zu einem Kabelbaum zusammengefassten, oder als Flachbandleitungen ausgeführten, elektrischen Leitungen 06 elektrisch verbundenen Kontaktmitteln 51 und den zu Kontaktflächen 38 ausgebildeten Leiterbahnen 33 der starrflexiblen Leiterplatte 03.

Die Kontaktmittel 51 der Direktsteckverbindung 50 sind von einem Rand her auf einen mit zu Kontaktflächen 38 ausgebildeten Leiterbahnen 33 versehenen und von dem mit seinen Leiterbahnen 33 von der OLED 02 erstkontaktierten Abschnitt 31, 32 verschiedenen zweiten Abschnitt 32 der starrflexiblen Leiterplatte 03 her aufschiebbar oder aufgeschoben.

Die Direktsteckverbindung 50 kann einen oder mehrere Randkontaktstecker 52 umfassen.

Der Randkontaktstecker 52 kann ein Gehäuse 53 aufweisen, welches das eine oder die mehreren Kontaktmittel 51 teilweise umgibt.

Jedes der Kontaktmittel 51 des Randkontaktsteckers 52 kann eine Klammer umfassen, von denen jede Klammer mit zwei einander gegenüberliegenden, einseitig an einer Verbindungsseite beispielsweise mittels eines Stegs vorzugsweise einstückig in dem Sinne federelastisch miteinander elektrisch leitfähig verbundenen Kontaktschwingen ausgeführt ist, dass die freien Enden 54 der Kontaktschwingen einer Klammer in einem Ausgangszustand aneinander anliegen oder um einen geringen Abstand von beispielsweise nur wenigen zehntel Millimetern einander gegenüberliegend voneinander beabstandet sind, und unter Überwindung der Federbelastung voneinander weg ausgelenkt werden können, wobei die Kontaktschwingen an der Verbindungsseite um einen vorgegebenen Abstand voneinander beabstandet sind, der vorzugsweise ausreicht, um einen mit zu Kontaktflächen 38 ausgebildeten Leiterbahnen 33, 39 versehenen zweiten Abschnitt 32 der starrflexiblen Leiterplatte 03 zwischen die Kontaktschwingen einzuschieben.

Der Abstand und damit die Dicke eines Kontaktflächen 38 aufweisenden zweiten Abschnitts 32 der starrflexiblen Leiterplatte 03 entspricht bevorzugt der Dicke einer Standard-Leiterplatte, besonders bevorzugt einer FR-4 Platine.

Dadurch kann der mindestens eine zweite Abschnitt 32 der starrflexiblen Leiterplatte 03 wie eine Standard-Leiterplatte ausgeführt sein. Dies vereinfacht die Herstellung der starrflexiblen Leiterplatte beispielsweise durch Tiefenfräsen.

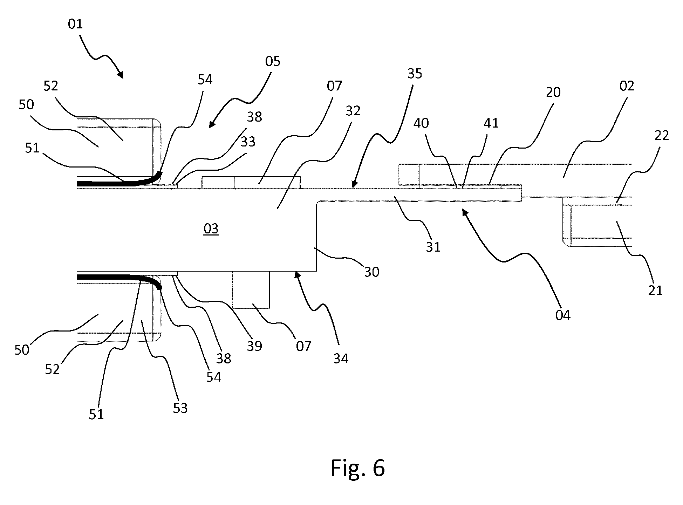

Zumindest in einem Bereich an den von der Verbindungsseite beabstandeten freien Enden 54 der Kontaktschwingen herrscht bevorzugt wie zuvor beschrieben ein geringerer Abstand, so dass ein zwischen die Kontaktschwingen der einen oder mehreren als Kontaktmittel 51 des Randkontaktsteckers 52 dienenden Klammern eingeschobener zweiter Abschnitt 32 der starrflexiblen Leiterplatte 03 zumindest im Bereich deren freier Enden 54 federelastisch eingeklemmt wird. Dabei ist von den freien Enden 54 her kommend vorzugsweise eine Aufweitung (Fig. 6) vorgesehen, um das Einschieben eines zweiten Abschnitts 32 der starrflexiblen Leiterplatte 03 zwischen die Kontaktschwingen zu erleichtern.

An den Kontaktmitteln sind beispielsweise zu einem Kabelbaum zusammengefasste elektrische Leitungen angeschlossen oder anschließbar.

Zur Erhöhung der Kontaktsicherheit zwischen den Kontaktmitteln 51 und den Leiterbahnen 33 der starrflexiblen Leiterplatte 03 kann letztere in dem mindestens einen der Zweitkontaktierung 05 dienenden zweiten Abschnitt 32 auch auf ihrer Unterseite 34 mit Leiterbahnen 39 versehen sein, die dort ebenfalls zu Kontaktflächen 38 ausgebildet sein können, und beispielsweise vermittels vertikaler elektrischer Verbindungen, beispielsweise in Form von Durchkontaktierungen, Durchsteigern oder VIAs (Vertical Interconnect Access) mit den zu Kontaktflächen 38 ausgebildeten Leiterbahnen 33 auf der die Leiterbahnebene bildenden Oberseite 35 elektrisch verbunden sind.

Die mindestens eine OLED 02 ist demnach durch Drahtbonden oder durch ACF-Bonding vermittels Leitkleber 41 an einem anderen, als dem zweiten Abschnitt 32, von dessen Rand her mindestens ein die Direktsteckverbindung 50 bildender Randkontaktstecker 52 unter Herstellung elektrischen Kontakts jedes seiner mit jeweils einer elektrischen Leitung 06 elektrisch verbundenen Kontaktmittel 51 mit einer eine Kontaktfläche 38 aufweisenden oder bildenden Leiterbahn 33, 39 der starrflexiblen Leiterplatte 03 aufschiebbar oder aufgeschobenen, mit den Leiterbahnen 33 der starrflexiblen Leiterplatte 03 erstkontaktiert.

Alternativ können zu Kontaktflächen 38 ausgebildete Leiterbahnen 39 auf der Unterseite 34 eines zweiten Abschnitts 32 einer elektrischen Kontaktierung einer durch Elektronikbauteile 07 gebildeten, auf der Unterseite 34 des entsprechenden zweiten Abschnitts 32 angeordneten Elektronikschaltung 70 dienen. Hierbei sind die Kontaktmittel 51 der die Zweitkontaktierung 05 bildenden Direktsteckverbindung vorzugsweise horizontal zweigeteilt, einmal für zu Kontaktflächen 38 ausgebildete Leiterbahnen 33 auf der Oberseite 35, einmal für zu Kontaktflächen 38 ausgebildete Leiterbahnen 39 auf der Unterseite 34.

Durch die Aussparung elektrisch isolierenden Materials 30 ist eine starrflexible Leiterplatte 03 in dem mindestens einen ersten Abschnitt 31 stark verjüngt, was der starrflexiblen Leiterplatte 03 in dem mindestens einen ersten Abschnitt 31 eine beispielsweise zum Einbau in begrenzte Bauräume vorteilhafte beispielsweise elastisch reversible, anelastisch plastische oder biegeschlaffe Biegsamkeit verschafft, wohingegen in wenigstens einem zweiten Abschnitt 32 das elektrisch isolierende Material 30 nach wie vor vorhanden ist, was der starrflexiblen Leiterplatte 03 in dem mindestens einen zweiten Abschnitt 32 eine zur Verwendung in Verbindung mit einer beispielsweise durch einen oder mehrere Randkontaktstecker 52 gebildeten Direktsteckverbindung 50 erforderliche Stabilität verschafft.

Dadurch, dass die starrflexible Leiterplatte 03 in dem mindestens einen ersten Abschnitt 31 stark verjüngt ist, ist zum Einbau und zur Anordnung einer oder mehrerer mit den Leiterbahnen 33, 39 der starrflexiblen Leiterplatte 03 elektrisch und mechanisch verbundener OLEDs 02 beispielsweise in einen Leuchteninnenraum einer Fahrzeugleuchte eine ausreichende Flexibilität gewährleistet. Gleichzeitig kann die elektrische Kontaktierung zwischen der beispielsweise als tiefengefräste FR-4 Platine ausgeführten, starrflexiblen Leiterplatte 03 und der mindestens einen OLED 02 auf einfache und gewohnte Art und Weise beispielsweise durch Draht-Bonden oder ACF-Bonden hergestellt werden, ohne dass undefinierte Lage und Ausrichtung Einfluss auf den Herstellungsprozess nehmen, wie dies bei Flexplatinen oft der Fall ist.

Die starrflexible Leiterplatte 03 kann mehrere, beispielsweise zwei, zweite Abschnitte 32 aufweisen, wobei zwischen zwei zweiten Abschnitten 32 jeweils ein erster Abschnitt 31 angeordnet ist.

Wichtig ist hervorzuheben, dass die elektrische Kontaktierung eine Reihe von vermittels starrflexibler Leiterplatten 03, beispielsweise tiefengefräster FR-4 Platinen, elektrisch kontaktierter OLEDs 02 umfassen kann, die untereinander ohne zusätzliche Steckverbindung elektrisch kontaktiert sind, indem immer via Direktsteckverbindung 50 eine mit einer OLED 02 per Erstkontaktierung 04 elektrisch kontaktierte starrflexible Leiterplatte 03, beispielsweise eine tiefengefräste FR-4 Platine, mit einer anderen, ebenfalls mit einer OLED 02 per Erstkontaktierung 04 elektrisch kontaktierten starrflexiblen Leiterplatte 03, beispielsweise tiefengefrästen FR-4 Platine elektrisch verbunden ist.

Hierdurch lassen sich Leitungsverbindungen zwischen als OLEDs 02 ausgeführten Lichtquellen von beispielsweise zum Einsatz in Fahrzeugleuchten vorgesehenen Leuchtmitteln ganz einsparen.

Die Direktsteckverbindung 50 der Zweitkontaktierung 05 der elektrischen Kontaktierung 01 kann einen Randkontaktstecker 52 mit einer Anzahl von Kontaktmitteln 51 umfassen, welche zumindest der Zahl von jeweils durch mindestens eine Kontaktfläche 38 gebildeten, beispielsweise zumindest einer Zahl von zum Betrieb wenigstens einer durch ein oder mehrere via der auf der starrflexiblen Leiterplatte 03 ausgebildeten Leiterbahnen 33 elektrisch kontaktierte, untereinander elektrisch verbundene Elektronikbauteile 07 gebildeten Einrichtung 70 erforderlichen, elektrischen Anschlüssen der starrflexiblen Leiterplatte 03 entspricht.

Bei der Einrichtung 70 kann es sich beispielsweise um eine Elektronikschaltung 71 handeln, die beispielsweise wenigstens einen Teil, etwa eine Ansteuereinrichtung, eines eine oder mehrere beispielsweise durch eine oder mehrere OLEDs 02 gebildete oder diese umfassende Lichtquellen aufweisenden Leuchtmittels einer Fahrzeugleuchte umfassen kann. Alternativ oder zusätzlich kann die Einrichtung 70 eine oder mehrere Lichtquellen eines Leuchtmittels einer Fahrzeugleuchte umfassen.

Zum Betrieb von OLEDs 02 als Lichtquellen für ein Leuchtmittel beispielsweise einer Fahrzeugleuchte können eine oder mehrere mehr oder minder komplexe Elektronikschaltungen 71 vorgesehen sein, die beispielsweise auf einem oder mehreren Leuchtmittelträgern des Leuchtmittels angeordnet und in einem Leuchteninnenraum der Fahrzeugleuchte beherbergt sein können. Für Beispiele solcher Elektronikschaltungen wird auf den allgemeinen Teil der vorliegenden Beschreibung verwiesen.

Eine die elektrische Kontaktierung 01 umfassende Vorrichtung 100 kann demnach ein oder mehrere mit Leiterbahnen 33, 39 der starrflexiblen Leiterplatte 03 verbundene Elektronikbauteile 07 und/oder eine hierdurch gebildete, beispielsweise eine Elektronikschaltung 71 bildende Einrichtung 70 umfassen, die zum Betrieb der OLED 02 erforderlich sein können.

Ein entsprechendes, die elektrische Kontaktierung 01 umfassendes und durch eine Vorrichtung 100 gebildetes, von einer solchen Vorrichtung 100 umfasstes oder eine entsprechende Vorrichtung 100 umfassendes Leuchtmittel kann zusätzlich zu der mindestens einen OLED 02 eine oder mehrere zusätzliche Lichtquellen umfassen, beispielsweise eine oder mehrere LEDs. Diese können wie OLEDs 02 auch zu deren Betrieb einer Elektronikschaltung 71 aus mehreren Elektronikbauteilen 07 bedürfen. Eine solche Elektronikschaltung 71 kann wie bereits ausgeführt durch ein oder mehrere mit Leiterbahnen 33, 39 der starrflexiblen Leiterplatte 03 elektrisch kontaktierte Elektronikbauteile 07 ausgebildet sein.

Demnach kann mindestens ein Elektronikbauteil 07 vermittels zumindest eines Teils der Leiterbahnen 33, 39 der starrflexiblen Leiterplatte 03 elektrisch kontaktiert auf einem oder mehreren Abschnitten 31, 32 der starrflexiblen Leiterplatte 03 vorgesehen sein.

Die vermittels der elektrischen Erstkontaktierung 04 mit den elektrischen Anschlüssen 20 wenigstens einer OLED 02 verbundenen Leiterbahnen 33 der starrflexiblen Leiterplatte 03 können somit direkt oder indirekt über eine durch ein oder mehrere Elektronikbauteile 07 gebildete Elektronikschaltung 71 mit den als elektrische Anschlüsse für die elektrische Zweitkontaktierung 05 dienenden Kontaktflächen 38 verbunden sein.

Zur elektrischen und mechanischen Befestigung eines oder mehrerer Elektronikbauteile 07 kann die starrflexible Leiterplatte 03 Pads und/oder Lötaugen aufweisen.

Für Beispiele zur elektrische Kontaktierung und Befestigung von Elektronikbauteilen 07 auf der starrflexiblen Leiterplatte 03 wird auf den allgemeinen Teil der vorliegenden Beschreibung verwiesen.

Ein oder mehrere Elektronikbauteile 07 können hierbei auf einem oder mehreren zweiten Abschnitten 32 der starrflexiblen Leiterplatte 03 angeordnet sein.

Vorteile ergeben sich unter Anderem dadurch, dass an die OLED 02 in unmittelbarer Nähe eine durch ein oder mehrere Elektronikbauteile 07 gebildete Ansteuerelektronik, Treiberelektronik, Verpolschutzdiode, etc. angebracht werden kann. Hierdurch ist ein relativ kompakter, modularer Aufbau möglich.

Durch die kurzen elektrischen Zuleitungen werden EMV (elektromagnetische Verträglichkeit)-Probleme minimiert. Hierdurch werden Störeinstrahlungen und - ausstrahlungen vom und in ein Fahrzeug bei in einer Fahrzeugleuchte eingesetzter, eine elektrische Kontaktierung 01 umfassender Vorrichtung 100 minimiert. Die kurzen elektrischen Wege wirken sich positiv dahingehend aus, dass die Antennenwirkung dieser kurzen Leitungen relativ klein ist und sie somit ausreichend wenig hochfrequente Strahlung einfangen oder aussenden kann.

Ein weiterer Vorteil der Anordnung besteht bezüglich eines Herstellungsverfahrens für eine die elektrische Kontaktierung umfassende Vorrichtung 100 und/oder eines einen Teil einer solchen Vorrichtung 100 umfassenden OLED-Moduls. Die Elektronikbauteile 07 auf der starrflexiblen Leiterplatte 03 können ohne Einschränkungen durch die temperatursowie feuchteempfindlichen OLEDs aufgelötet werden, beispielsweise in einem Reflow-Prozess oder mittels einer Lötwelle. Somit kann die starrflexible Leiterplatte 03 wie in den Standardprozessen vorgesehen verarbeitet werden. Zeitlich hieran im Anschluss wird die OLED 02 dann mit der starrflexiblen Leiterplatte 03 durch Herstellung der Erstkontaktierung 04 verbunden. Die OLED 02 wird somit im Herstellungsprozess durch Herstellung der Erstkontaktierung 04 erst zum Schluss angebracht. Dies sorgt auch für eine zusätzliche Sicherheit, die OLED 02 oder die Erstkontaktierung 04 zwischen OLED 02 und beispielsweise Elektronikschaltung 71 nicht in einem frühen Stadium der Prozesskette zu beschädigen.

Die elektrische Erstkontaktierung 04 ist bevorzugt in mindestens einem ersten Abschnitt 31 vorgesehen.

Wichtig ist hervorzuheben, dass bei der elektrischen Kontaktierung 01 eine OLED 02 auf einem Träger 21 mit einer beispielsweise durch ein Klebeband, einen Flüssigkleber oder ähnliches hergestellte Klebeschicht 22 verbunden sein kann. Die OLED 02 wiederum ist beispielsweise mittels ACF-Bonding mit einer beispielsweise als tiefengefräste FR4-Platine ausgeführten, starrflexiblen Leiterplatte 03 elektrisch und mechanisch erstkontaktiert. Der durch die elektrisch leitfähige Verbindung 40 gebildete Bereich der Erstkontaktierung 04 sorgt für die mechanische und elektrische Verbindung von OLED 02 und starrflexibler Leiterplatte 03. Die mechanische Halterung kann auch durch andere Elemente, beispielsweise Konstruktionselemente, verstärkt werden oder sein.

Für die Durchführung des ACF-Bondings in Verbindung mit einer OLED 02 ist es vorteilhaft, wenn der Leiterbahnträger nicht zu dick ist, um einen möglichst geringen Wärmeeintrag sowohl durch das ACF-Bonding selbst, als auch durch die Anordnung und den Betrieb beispielsweise auf dem Leiterbahnträger gegebenenfalls vorgesehener Elektronikbauteile sicherzustellen.

Ein zu großer Wärmeeintrag könnte die OLED 02 schädigen und/oder sie unerwünscht altern lassen, noch bevor sie sinnvoll eingesetzt werden kann für ihre Leuchtaufgabe.

Für die Durchführung des ACF-Bondings ist es ferner vorteilhaft einen erforderlichen Druck auf den durch die elektrisch leitfähige Verbindung 40 gebildeten Bereich der Erstkontaktierung 04 beispielsweise mit einem Stempelwerkzeug gut aufbringen zu können.

Zusammengefasst eignet sich in vorteilhafter Weise ein erster Abschnitt 31 einer starrflexiblen Leiterplatte 03 zur Herstellung der Erstkontaktierung 04.

Außerdem ist die Flexibilität eines ersten Abschnitts 31 einer starrflexiblen Leiterplatte 03 für den Einbau der OLED 02 von Vorteil. Hierdurch sind verschiedene Einbaulagen von Elektronik und OLED 02 möglich, ohne ein zusätzliches Bauteil zu benötigen.

Es wird kein weiterer Fügeprozess wie beispielsweise Warmverstemmen, Vernieten wie bei einer Flexplatine benötigt, die noch an einem Träger zu befestigen wäre.

Für die Zweitkontaktierung 05 wird vorzugsweise ein Randkontaktstecker 52 eingesetzt. Dieser kann über ein dahinterliegendes Bauteil 08, wie beispielsweise ein Leuchtengehäuse oder eine hieran angeformte Rippe, gegen unbeabsichtigtes Abrutschen gesichert sein. Hierdurch kann der beispielsweise gegen Verpolung durch einen oder mehrere Vorsprünge mit korrespondierenden Nuten am mit als Kontaktflächen 38 ausgebildeten Leiterbahnen 33 versehenen zweiten Abschnitt 32 vorgesehenen Nuten kodierten Randkontaktstecker 52 im eingebauten Zustand nicht mehr vom entsprechenden zweiten Abschnitt 32 der starrflexiblen Leiterplatte 03 rutschen. Die Kodierung des Randkontaktsteckers 52 kann auch dafür sorgen, dass der Randkontaktstecker 52 nicht seitlich verrutschen kann.

Der Randkontaktstecker 52 ist mit den Leiterbahnen 33, 39 der starrflexiblen Leiterplatte 03 über die Kontaktierungsbereiche bildenden, als Kontaktflächen 38 ausgebildeten Leiterbahnen 33, 39 elektrisch verbunden.

Im Vergleich zu der Verwendung von Flexplatinen wird ein mechanisches Hängenbleiben während des Umgangs beispielsweise während der Montage der OLED 02 weitestgehend vermieden. Somit werden die Verarbeitungsprozesskette einschließlich des Verfahrens und die Prozesssicherheit verbessert sowie der Ausschuss verringert.

Insgesamt können mit Hilfe der Erfindung Kosten gespart werden und kompakte sowie flexibel einsetzbare, einstückige OLED-Integrationslösungen und/oder -module gefunden werden.

Die starrflexible Leiterplatte 03 ist einstückig und bedarf keines zusätzlichen Trägers beispielsweise aus Kunststoff oder Metall, da sie selbst schon relativ steif aufgebaut ist und mit einem Randkontaktstecker 52 ohne Probleme kontaktiert werden kann.

Vorteile ergeben sich durch eine Minimierung der Kosten durch Substitution des Polyimid-Materials, eine verbesserte Dimensionsstabilität des Produktes, dreidimensionale Einbaumöglichkeiten, eine Kostenreduzierung in der Beschaffung, Logistik und Fertigung durch die Einsparung zusätzlicher Verbindungstechnik, wie beispielsweise Kabel- und Steckersysteme, sowie durch eine Erhöhung der Zuverlässigkeit durch Minimierung der Systemschnittstellen.

Die elektrische Kontaktierung 01 kann alternativ oder zusätzlich einzelne oder eine Kombination mehrerer einleitend in Verbindung mit dem Stand der Technik und/oder in einem oder mehreren der zum Stand der Technik erwähnten Dokumente und/oder in der noch folgenden Beschreibung erwähnte Merkmale aufweisen.

Die elektrische Kontaktierung 01 kann durch oder in Zusammenhang mit einer Vorrichtung 100 verwirklicht sein, welche:
- eine starrflexible Leiterplatte 03 bestehend aus einem elektrisch isolierenden Material 30 und auf dieses aufgebrachten Leiterbahnen 33, 39, wobei in wenigstens einem ersten Abschnitt 31 das elektrisch isolierende Material 30 über die gesamte Breite der starrflexiblen Leiterplatte 03 wenigstens zwischen zwei parallel zu der mit den Leiterbahnen 33 versehenen Oberseite 35 verlaufender, einander im Bereich der starrflexiblen Leiterplatte 03 nicht schneidender Geraden 36, 37 von einer den Leiterbahnen 33 abgewandten Unterseite 34 der starrflexiblen Leiterplatte 03 her zumindest zum Teil ausgespart ist, wohingegen in wenigstens einem sich an eine der Geraden 36, 37 anschließenden zweiten Abschnitt 32 das elektrisch isolierende Material 30 frei von einer Aussparung oder zumindest nur mit loch- oder sacklochförmigen Aussparungen, beispielsweise zur mechanischen Befestigung oder THT-Montage von Elektronikbauteilen 07 ausgeführt ist, wobei zumindest ein Teil der Leiterbahnen 33, 39 in wenigstens einem zweiten Abschnitt 32 einer elektrischen Zweitkontaktierung 05 dienende Kontaktflächen 38 aufweisen,
- mindestens eine OLED 02, deren elektrische Anschlüsse 20 vermittels einer elektrischen Erstkontaktierung 04 mit Leiterbahnen 33, 39 der starrflexiblen Leiterplatte 03 elektrisch verbunden sind, und
- mindestens eine eine elektrische Zweitkontaktierung 05 bildende Direktsteckverbindung 50 mit Kontaktmitteln 51, welche mit der Weiterkontaktierung beispielsweise innerhalb einer Fahrzeugleuchte dienenden elektrischen Leitungen 06 elektrisch verbunden sind, und welche von einem Rand wenigstens eines mit Kontaktflächen 38 ausgeführten zweiten, jedoch von dem mit seinen Leiterbahnen 33 von der mindestens einen OLED erstkontaktierten Abschnitt 31, 32 verschiedenen Abschnitts 32 her auf die starrflexible Leiterplatte 03 aufgeschoben einen elektrischen Kontakt mit je mindestens einer Kontaktfläche 38 herstellen,
umfasst. Dadurch ist die Erstkontaktierung 04 biegsam gegenüber der Zweitkontaktierung 05 angeordnet.

Die Vorrichtung 100 kann ein beispielsweise für eine Fahrzeugleuchte vorgesehenes Leuchtmittel ganz oder teilweise umfassen, oder von einem beispielsweise für eine Fahrzeugleuchte vorgesehenen Leuchtmittel ganz oder teilweise umfasst sein.

Die Vorrichtung 100 kann einzelne oder Kombinationen der zur elektrischen Kontaktierung 01 beschriebenen Merkmale aufweisen.

Die Erfindung kann ferner verwirklicht sein durch eine Fahrzeugleuchte mit einer zuvor beschriebenen elektrischen Kontaktierung 01 mindestens einer OLED 02 und/oder mit einer eine solche elektrische Kontaktierung 01 mindestens einer OLED 02 umfassenden Vorrichtung 100, die beispielsweise als ein Leuchtmittel der Fahrzeugleuchte ausgebildet sein kann, ein solches Leuchtmittel umfassen kann, oder ganz oder teilweise von einem entsprechenden Leuchtmittel der Fahrzeugleuchte umfasst sein kann.

### Die Fahrzeugleuchte kann als eine Heckleuchte ausgeführt sein.

Hinsichtlich Beispiele einzelner oder von Kombinationen von denkbaren Merkmalen einer solchen Fahrzeugleuchte wird auf den allgemeinen Teil der vorliegenden Beschreibung verwiesen.

Wichtig ist hervorzuheben, dass die in der vorliegenden Beschreibung verwendete Bezeichnung Randkontaktstecker 52 stellvertretend für jegliche zur Herstellung einer Direktsteckverbindung 50 geeigneten Steckverbinder steht.

Die elektrische Kontaktierung 01 kann alternativ oder zusätzlich einzelne oder eine Kombination mehrerer einleitend in Verbindung mit dem Stand der Technik und/oder in einem oder mehreren der zum Stand der Technik erwähnten Dokumente und/oder in der vorangehenden Beschreibung zu den in den Zeichnungen dargestellten Ausführungsbeispielen beschriebene Merkmale aufweisen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung von Fahrzeugleuchten, insbesondere Kraftfahrzeugleuchten gewerblich anwendbar.

### Bezugszeichenliste

- 01: elektrische Kontaktierung
- 02: OLED
- 03: starrflexible Leiterplatte
- 04: Erstkontaktierung
- 05: Zweitkontaktierung
- 06: Leitung
- 07: Elektronikbauteil
- 08: Bauteil
- 20: elektrischer Anschluss der OLED 02
- 21: Träger
- 22: Klebeschicht
- 30: elektrisch isolierendes Material
- 31: erster Abschnitt
- 32: zweiter Abschnitt
- 33: Leiterbahn
- 34: Unterseite
- 35: Oberseite
- 36: Gerade
- 37: Gerade
- 38: Kontaktfläche
- 39: Leiterbahn
- 40: elektrisch leitfähige Verbindung der Erstkontaktierung 04
- 41: Leitkleber
- 50: Direktsteckverbindung der Zweitkontaktierung 05
- 51: Kontaktmittel
- 52: Randkontaktstecker
- 53: Gehäuse
- 54: freies Ende
- 70: Einrichtung
- 71: Elektronikschaltung
- 100: Vorrichtung

## Patentansprüche

1. Elektrische Kontaktierung (01) mindestens einer OLED (02), umfassend:
- mindestens eine wenigstens einen ersten Abschnitt (31) und zumindest einen zweiten Abschnitt (32) aufweisende starrflexible Leiterplatte (03) bestehend aus elektrisch isolierendem Material (30) mit daran haftenden Leiterbahnen (33, 39), wobei in dem zumindest einen ersten Abschnitt (31) das elektrisch isolierende Material (30) von der Unterseite (34) der starrflexiblen Leiterplatte (03) her gesehen zwischen zwei parallel zu der mit Leiterbahnen (33) versehenen Oberseite (35) verlaufenden Geraden (36, 37) zumindest teilweise, höchstens jedoch bis zu den Leiterbahnen (33) der Oberseite (35) ausgespart ist, wohingegen der wenigstens eine zweite Abschnitt (32) frei von einer solchen Aussparung ist, und wobei zumindest ein Teil der Leiterbahnen (33, 39) in wenigstens einem zweiten Abschnitt (32) zu Kontaktflächen (38) ausgebildet sind,
- eine elektrische Erstkontaktierung (04) der mindestens einen OLED (02) umfassend elektrisch leitfähige Verbindungen (40) zwischen je einem elektrischen Anschluss (20) der OLED (02) und je einer Leiterbahn (33, 39) der starrflexiblen Leiterplatte (03),
- eine elektrische Zweitkontaktierung (05) der mindestens einen OLED (02) umfassend mindestens eine Direktsteckverbindung (50) zwischen mit der Weiterkontaktierung dienenden elektrischen Leitungen (06) elektrisch verbundenen Kontaktmitteln (51) und den zu Kontaktflächen (38) ausgebildeten Leiterbahnen (33, 39) der starrflexiblen Leiterplatte (03), wobei die Kontaktmittel (51) der Direktsteckverbindung (50) von einem Rand her auf einen mit zu Kontaktflächen (38) ausgebildeten Leiterbahnen (33, 39) versehenen und von dem mit seinen Leiterbahnen (33) von der OLED (02) erstkontaktierten Abschnitt (31, 32) verschiedenen zweiten Abschnitt (32) der starrflexiblen Leiterplatte (03) her aufschiebbar oder aufgeschoben sind.

2. Elektrische Kontaktierung nach Anspruch 1, wobei die elektrische Erstkontaktierung (04) der mindestens einen OLED (02) durch Drahtbonden oder durch ACF-Bonding vermittels Leitkleber (41) hergestellte elektrisch leitfähige Verbindungen (40) umfasst.

3. Elektrische Kontaktierung nach Anspruch 1 oder 2, wobei die Leiterbahnen (33, 39) aus Kupfer geätzt sind und/oder als isolierendes Material (30) faserverstärkter Kunststoff und/oder FR-4 vorgesehen ist.

4. Elektrische Kontaktierung nach Anspruch 1, 2 oder 3, wobei die Aussparung des elektrisch isolierenden Materials (30) im ersten Abschnitt (31) im Herstellungsprozess der starrflexiblen Leiterplatte (03) vorgesehen wird, oder die starrflexible Leiterplatte (03) aus einer starren Leiterplatte hergestellt wird, indem das elektrisch isolierende Material (30) im ersten Abschnitt (31) durch Tiefenfräsen entfernt wird.

5. Elektrische Kontaktierung nach einem der Ansprüche 1 bis 4, wobei die starrflexible Leiterplatte (03) mehrere zweite Abschnitte (32) aufweist, zumindest zwischen denen jeweils ein erster Abschnitt (31) angeordnet ist.

6. Elektrische Kontaktierung nach einem der voranstehenden Ansprüche, wobei die jeweils mit einem der Kontaktmittel (51) der mindestens einen Direktsteckverbindung (50) elektrisch verbundenen, der Weiterkontaktierung dienenden Leitungen (06) zu einem Kabelbaum zusammengefasst oder als Einzelleitungen oder als Flachbandleitungen ausgeführt sind.

7. Elektrische Kontaktierung nach einem der voranstehenden Ansprüche, wobei sie eine Reihe von vermittels starrflexibler Leiterplatten (03) elektrisch kontaktierter OLEDs (02) umfasst, die untereinander elektrisch kontaktiert sind, indem immer via Direktsteckverbindung (50) eine mit einer OLED (02) per Erstkontaktierung (04) elektrisch kontaktierte starrflexible Leiterplatte (03) mit einer anderen, ebenfalls mit einer OLED (02) per Erstkontaktierung (04) elektrisch kontaktierten starrflexiblen Leiterplatte (03) elektrisch verbunden ist.

8. Elektrische Kontaktierung nach einem der voranstehenden Ansprüche, wobei die Direktsteckverbindung (50) einen Randkontaktstecker (52) mit einer Anzahl von Kontaktmitteln (51) umfasst, welche zumindest der Zahl von jeweils durch mindestens eine Kontaktfläche (38) gebildeten elektrischen Anschlüssen der starrflexiblen Leiterplatte (03) entspricht.

9. Elektrische Kontaktierung nach Anspruch 8, wobei
- der Randkontaktstecker (52) ein Gehäuse (53) aufweist, welches das eine oder die mehreren Kontaktmittel (51) teilweise umgibt, und/oder
- jedes der Kontaktmittel (51) des Randkontaktsteckers (52) eine Klammer umfasst, von denen jede Klammer mit zwei einander gegenüberliegenden, einseitig an einer Verbindungsseite in dem Sinne federelastisch miteinander elektrisch leitfähig verbundenen Kontaktschwingen ausgeführt ist, dass die freien Enden (54) der Kontaktschwingen einer Klammer in einem Ausgangszustand aneinander anliegen oder um einen geringen Abstand einander gegenüberliegend voneinander beabstandet sind, und unter Überwindung der Federbelastung voneinander weg ausgelenkt werden können, wobei die Kontaktschwingen an der Verbindungsseite um einen vorgegebenen Abstand voneinander beabstandet sind, der ausreicht, um einen zweiten Abschnitt (32) der starrflexiblen Leiterplatte (03) zwischen die Kontaktschwingen einzuschieben.

10. Elektrische Kontaktierung nach einem der voranstehenden Ansprüche, wobei mindestens ein Elektronikbauteil (07) vermittels zumindest eines Teils der Leiterbahnen (33, 39) der starrflexiblen Leiterplatte (03) elektrisch kontaktiert auf einem oder mehreren Abschnitten (31, 32) der starrflexiblen Leiterplatte (03) vorgesehen ist.

11. Elektrische Kontaktierung nach Anspruch 10, wobei die starrflexible Leiterplatte (03) Pads und/oder Lötaugen zur elektrischen und mechanischen Befestigung eines oder mehrerer Elektronikbauteile (07) aufweist.

12. Elektrische Kontaktierung nach Anspruch 10 oder 11, wobei ein oder mehrere Elektronikbauteile (07) auf einem oder mehreren zweiten Abschnitten (32) der starrflexiblen Leiterplatte (03) angeordnet sind.

13. Elektrische Kontaktierung nach einem der voranstehenden Ansprüche, wobei die elektrische Erstkontaktierung (04) in mindestens einem ersten Abschnitt (31) vorgesehen ist.

14. Fahrzeugleuchte mit einer elektrischen Kontaktierung (01) mindestens einer OLED (02) nach einem der voranstehenden Ansprüche.

15. Fahrzeugleuchte nach Anspruch 14, wobei die Fahrzeugleuchte als eine Heckleuchte ausgeführt ist.

## Geänderte Patentansprüche

### Geänderte Patentansprüche gemäss Regel 137(2) EPÜ.

1. Elektrische Kontaktierung (01) mindestens einer OLED (02), umfassend:
- mindestens eine wenigstens einen ersten Abschnitt (31) und zumindest einen zweiten Abschnitt (32) aufweisende starrflexible Leiterplatte (03) bestehend aus elektrisch isolierendem Material (30) mit daran haftenden Leiterbahnen (33, 39), wobei in dem zumindest einen ersten Abschnitt (31) das elektrisch isolierende Material (30) von der Unterseite (34) der starrflexiblen Leiterplatte (03) her gesehen zwischen zwei parallel zu der mit Leiterbahnen (33) versehenen Oberseite (35) verlaufenden Geraden (36, 37) zumindest teilweise, höchstens jedoch bis zu den Leiterbahnen (33) der Oberseite (35) ausgespart ist, wohingegen der wenigstens eine zweite Abschnitt (32) frei von einer solchen Aussparung ist, und wobei zumindest ein Teil der Leiterbahnen (33, 39) in wenigstens einem zweiten Abschnitt (32) zu Kontaktflächen (38) ausgebildet sind,
- eine elektrische Erstkontaktierung (04) der mindestens einen OLED (02) umfassend elektrisch leitfähige Verbindungen (40) zwischen je einem elektrischen Anschluss (20) der OLED (02) und je einer Leiterbahn (33, 39) der starrflexiblen Leiterplatte (03),
- eine elektrische Zweitkontaktierung (05) der mindestens einen OLED (02) umfassend mindestens eine Direktsteckverbindung (50) zwischen mit der Weiterkontaktierung dienenden elektrischen Leitungen (06) elektrisch verbundenen Kontaktmitteln (51) und den zu Kontaktflächen (38) ausgebildeten Leiterbahnen (33, 39) der starrflexiblen Leiterplatte (03), wobei die Kontaktmittel (51) der Direktsteckverbindung (50) von einem Rand her auf einen mit zu Kontaktflächen (38) ausgebildeten Leiterbahnen (33, 39) versehenen und von dem mit seinen Leiterbahnen (33) von der OLED (02) erstkontaktierten Abschnitt (31, 32) verschiedenen zweiten Abschnitt (32) der starrflexiblen Leiterplatte (03) her aufschiebbar oder aufgeschoben sind,
wobei die elektrische Erstkontaktierung (04) in mindestens einem ersten Abschnitt (31) vorgesehen ist.

2. Elektrische Kontaktierung nach Anspruch 1, wobei die elektrische Erstkontaktierung (04) der mindestens einen OLED (02) durch Drahtbonden oder durch ACF-Bonding vermittels Leitkleber (41) hergestellte elektrisch leitfähige Verbindungen (40) umfasst.

3. Elektrische Kontaktierung nach Anspruch 1 oder 2, wobei die Leiterbahnen (33, 39) aus Kupfer geätzt sind und/oder als isolierendes Material (30) faserverstärkter Kunststoff und/oder FR-4 vorgesehen ist.

4. Elektrische Kontaktierung nach Anspruch 1, 2 oder 3, wobei die Aussparung des elektrisch isolierenden Materials (30) im ersten Abschnitt (31) im Herstellungsprozess der starrflexiblen Leiterplatte (03) vorgesehen wird, oder die starrflexible Leiterplatte (03) aus einer starren Leiterplatte hergestellt wird, indem das elektrisch isolierende Material (30) im ersten Abschnitt (31) durch Tiefenfräsen entfernt wird.

5. Elektrische Kontaktierung nach einem der Ansprüche 1 bis 4, wobei die starrflexible Leiterplatte (03) mehrere zweite Abschnitte (32) aufweist, zumindest zwischen denen jeweils ein erster Abschnitt (31) angeordnet ist.

6. Elektrische Kontaktierung nach einem der voranstehenden Ansprüche, wobei die jeweils mit einem der Kontaktmittel (51) der mindestens einen Direktsteckverbindung (50) elektrisch verbundenen, der Weiterkontaktierung dienenden Leitungen (06) zu einem Kabelbaum zusammengefasst oder als Einzelleitungen oder als Flachbandleitungen ausgeführt sind.

7. Elektrische Kontaktierung nach einem der voranstehenden Ansprüche, wobei sie eine Reihe von vermittels starrflexibler Leiterplatten (03) elektrisch kontaktierter OLEDs (02) umfasst, die untereinander elektrisch kontaktiert sind, indem immer via Direktsteckverbindung (50) eine mit einer OLED (02) per Erstkontaktierung (04) elektrisch kontaktierte starrflexible Leiterplatte (03) mit einer anderen, ebenfalls mit einer OLED (02) per Erstkontaktierung (04) elektrisch kontaktierten starrflexiblen Leiterplatte (03) elektrisch verbunden ist.

8. Elektrische Kontaktierung nach einem der voranstehenden Ansprüche, wobei die Direktsteckverbindung (50) einen Randkontaktstecker (52) mit einer Anzahl von Kontaktmitteln (51) umfasst, welche zumindest der Zahl von jeweils durch mindestens eine Kontaktfläche (38) gebildeten elektrischen Anschlüssen der starrflexiblen Leiterplatte (03) entspricht.

9. Elektrische Kontaktierung nach Anspruch 8, wobei
- der Randkontaktstecker (52) ein Gehäuse (53) aufweist, welches das eine oder die mehreren Kontaktmittel (51) teilweise umgibt, und/oder
- jedes der Kontaktmittel (51) des Randkontaktsteckers (52) eine Klammer umfasst, von denen jede Klammer mit zwei einander gegenüberliegenden, einseitig an einer Verbindungsseite in dem Sinne federelastisch miteinander elektrisch leitfähig verbundenen Kontaktschwingen ausgeführt ist, dass die freien Enden (54) der Kontaktschwingen einer Klammer in einem Ausgangszustand aneinander anliegen oder um einen geringen Abstand einander gegenüberliegend voneinander beabstandet sind, und unter Überwindung der Federbelastung voneinander weg ausgelenkt werden können, wobei die Kontaktschwingen an der Verbindungsseite um einen vorgegebenen Abstand voneinander beabstandet sind, der ausreicht, um einen zweiten Abschnitt (32) der starrflexiblen Leiterplatte (03) zwischen die Kontaktschwingen einzuschieben.

10. Elektrische Kontaktierung nach einem der voranstehenden Ansprüche, wobei mindestens ein Elektronikbauteil (07) vermittels zumindest eines Teils der Leiterbahnen (33, 39) der starrflexiblen Leiterplatte (03) elektrisch kontaktiert auf einem oder mehreren Abschnitten (31, 32) der starrflexiblen Leiterplatte (03) vorgesehen ist.

11. Elektrische Kontaktierung nach Anspruch 10, wobei die starrflexible Leiterplatte (03) Pads und/oder Lötaugen zur elektrischen und mechanischen Befestigung eines oder mehrerer Elektronikbauteile (07) aufweist.

12. Elektrische Kontaktierung nach Anspruch 10 oder 11, wobei ein oder mehrere Elektronikbauteile (07) auf einem oder mehreren zweiten Abschnitten (32) der starrflexiblen Leiterplatte (03) angeordnet sind.

13. Fahrzeugleuchte mit einer elektrischen Kontaktierung (01) mindestens einer OLED (02) nach einem der voranstehenden Ansprüche.

14. Fahrzeugleuchte nach Anspruch 13, wobei die Fahrzeugleuchte als eine Heckleuchte ausgeführt ist.
